# EUROPEAN PATENT APPLICATION

(11) **EP 4 481 906 A2**
(43) Date of publication of application: **25.12.2024**
(21) Application number: 24203420.5
(22) Date of filing: 14.04.2022
(51) Int. Cl.: H01M 50/114

(54) **INTELLIGENT LEAD-ACID BATTERY SYSTEM AND METHOD OF OPERATING THE SAME**

(30) Priority: 15.04.2021 US 202163175486 P; 21.05.2021 US 202163191658 P; 26.07.2021 US 202163225718 P; 10.09.2021 US 202163242867 P; 15.10.2021 US 202163256420 P; 03.01.2022 US 202263296010 P; 27.01.2022 US 202263303854 P; 03.03.2022 US 202263316364 P
(62) Divisional of application: 22726849.7
(71) Applicant: CPS Technology Holdings LLC, New York, New York 10281 (US); Clarios Germany GmbH & Co. KG, 30419 Hannover (DE)
(72) Inventor: JIN, Zhihong H., Pewaukee, 53072 (US); FENG, Lu, Sussex, 53089 (US); SONG, Wei, Milwaukee, 53209 (US); SEARL, Jason D., Bayside, 53217 (US); LIEDHEGER, Joseph E., Wauwatosa, 53213 (US); PATEL, Dharmendra B., Menomonee Falls, 53501 (US); RIGBY, Craig W., Milwaukee, 53217 (US); PERRY, Wyatt M., Fox Point, 53217 (US); FUHR, Jason, Sussex, 53089 (US); CIURLIK, Kathryn Marie, Racine, 53402 (US); DUELL, Roderique, 30169 Hannover (DE); VARATHARAJAH, Arunraj, Menomonee Falls, 53051 (US); THIEL, Tyler, Germantown, 53022 (US)
(74) Representative: Meissner Bolte Partnerschaft mbB

(57) **Abstract**

The invention relates to a method of monitoring a lead-acid battery system having a lead-acid battery with (n) battery cells, the method comprising: sensing (n) cell voltages associated with the (n) cells, each cell voltage of the (n) cell voltages being associated with a respective cell; and determining a state of the lead-acid battery based on the (n) cell voltages.

## Description

### RELATED APPLICATIONS

This application claims the benefit of the following provisional applications, each of which is incorporated herein by reference in their entireties: US Patent Application No. 63/175,486, filed on April 15, 2021; US Patent Application No. 63/191,658, filed on May 21, 2021; US Patent Application No. 63/225,718, filed on July 26, 2021; US Patent Application No. 63/242,867, filed on September 10, 2021; US Patent Application No. 63/256,420, filed on October 15, 2021; US Patent Application No. 63/296,010, filed on January 3, 2022; US Patent Application No. 63/303,854, filed on January 27, 2022; and US Patent Application No. 63/316,364, filed on March 3, 2022.

### BACKGROUND

This application relates to lead-acid batteries. An example lead-acid battery is an absorbent glass mat (AGM) battery.

Traditional lead-acid batteries typically do not include any intelligence or communication capabilities.

One example environment for a lead-acid battery is a vehicle. A conventional vehicle with a conventional internal combustion engine (ICE) might include, for example, a traditional flooded lead-acid battery. A vehicle with a conventional internal combustion engine (ICE) or a start-stop system or a mild-hybrid engine might include a traditional AGM lead-acid battery. Some vehicles, such as some mild-hybrid engine vehicles, may also include a battery not based on lead-acid. Other vehicle types and battery arrangements are known. However, as vehicles become more automated (or autonomous) and as they become more electric, battery intelligence, reliability, and performance need to increase.

Known battery sensors coupled to traditional lead-acid batteries can currently provide parameters related to the overall health of the battery. Example battery sensors include a voltage sensor for sensing the overall battery voltage and a current sensor for sensing the battery current provided by the battery. However, individual cell failure in lead-acid batteries often causes battery health issues and/or deterioration that is not easily detected.

For some environments, detecting individual cell health and/or deterioration of a lead-acid battery can enable a user to detect a potential battery failure more quickly. This would allow the user more time to replace the lead-acid battery before failure.

In some situations, some field batteries fail due to insufficient charge. Additionally, some field batteries fail due to excessive overcharge which cause battery corrosion and internal short circuit.

In further situations, the health information of the individual lead-acid battery cells may be used during a recycling process to reduce waste and/or speed up the recycling process by handling the failed cells differently than the healthy cells.

Thus, in embodiments, a method of monitoring the cells of a lead-acid battery on an individual level is desired. Further desired in embodiments is an improved lead-acid battery than can monitor a parameter associated with a cell of a lead-acid battery. Also desired in embodiments is a method of determining a state of the lead-acid battery. Further improvements over prior lead-acid batteries are desired.

### SUMMARY

Disclosed herein are intelligent or "smart" lead-acid battery systems. An intelligent lead-acid battery system can support multiple autonomy levels. An intelligent lead-acid battery system can also provide solutions to the safety and security of lead-acid batteries not currently known and/or in solutions were lead-acid batteries have not been used.

An example intelligent lead-acid battery is an intelligent or "smart" absorbent glass mat (AGM) solution. An intelligent AGM battery system includes "smart" sensor technology to predict the battery's state of health, state of charge, state of function, life expectancy, charging and discharging capability, etc. The intelligent AGM battery system can also, for example, encourage and promote a proactive replacement.

An intelligent battery system can understand the battery's status, which can allow for modification of the charging/discharging of the system and/or operation of the vehicle (e.g., state of function). This enables OEMs to optimize performance of the vehicle (e.g., fuel consumption, emissions, performs) and improves the consumer's experience.

In some embodiments, cell voltage monitoring allows better charging management to ensure battery is neither undercharged nor overcharged. As a result, battery life can be extended. For start and stop applications, where battery state of charge (SOC) needs to be controlled, cell voltage monitoring will offer better fuel economy if paired with a vehicle, for example.

Example parameters sensed by the intelligent battery system can include one or more of the following: battery voltage, battery current, cell voltage, cell current, partial battery voltage, partial battery current, battery temperature, cell temperature, ambient or environment temperature, compartment temperature, battery pressure, cell pressure, cell state of charge, battery state of charge, etc.

The intelligent battery system of the disclosure allows for one or more of the following:
- improved monitoring of the state of function of the battery;
- improved monitoring of the state of health of the battery;
- improved monitoring of the state of charge of the battery;
- proactive replacement by the battery system, the apparatus the battery system is in (e.g., vehicle), or both;
- improved modification of state of charge of the battery operation;
- aggressive smart charging;
- improve reliability of battery diagnostic in battery state of charge;
- state of health and power capability; and
- detect battery thermal run away.

In at least one example lead-acid battery system described herein, the battery system includes a housing defining at least in part multiple compartments. A first compartment may be referred to as a "cells" compartment, and a second compartment may be referred to as a "battery monitoring system (BMS)" compartment. The housing can include a wall disposed between the cells compartment and the BMS compartment. A plurality of battery cells is housed in the cells compartment. The plurality of battery cell has a plurality of posts. A first post and a second post protrude through the wall from the cells compartment to the BMS compartment. A battery monitor system (BMS) is housed by the BMS compartment. The BMS includes a voltage sensor electrically coupled to the first post and the second post and can sense a voltage less than the battery voltage. An example of a voltage less than the battery voltage is a cell voltage. Another example of a voltage less than the battery voltage is a voltage for a plurality of cells (e.g., 2 cells) but not the total voltage for the plurality of cells (e.g., 6 cells if the battery system consists of 6 cells).

In one or more embodiments, multiple smaller posts (e.g., strap posts) are positioned on straps of the battery cells. The strap posts may be operable to measure a voltage of individual battery cells. The strap posts extend through a battery housing cover and into the BMS compartment. The strap posts are sealed, in at least one construction, using o-rings and an epoxy. It may also be a soldered connection of the strap post to a lead bushing molded in the cover.

In one embodiment, a method of monitoring a lead-acid battery system comprising a lead-acid battery having a plurality of cells is disclosed. The method can include sensing a first parameter associated with a first one or more cells of the plurality of cells, sensing a second parameter associated with a second one or more cells of the plurality of cells, and determining a state of the lead-acid battery based on the first parameter and the second parameter. The second one or more cells can be different from the first one or more cells. Also disclosed is a lead-acid battery system performing the method, and an apparatus or system (e.g., vehicle) including the lead-acid battery system.

In another embodiment, a method of monitoring a lead-acid battery system comprising a lead-acid battery having a plurality of cells is disclosed. The method includes sensing a first voltage of a first number of cells of the plurality of cells, sensing a second voltage of a second number of cells of the plurality of cells, and determining a state of the lead-acid battery based on the first voltage and the second voltage. The first number can be greater than one and less than the plurality of cells, and the second number can be greater than one and less than the plurality of cells. Also disclosed is a lead-acid battery system performing the method, and an apparatus or system (e.g., vehicle) including the lead-acid battery system.

In yet another embodiment, a method of monitoring a lead-acid battery system having a lead-acid battery with (n) battery cells is disclosed. The method includes sensing (n) cell voltages associated with the (n) cells, each cell voltage of the (n) cell voltages being associated with a respective cell, and determining a state of the lead-acid battery based on the (n) cell voltages. Also disclosed is a lead-acid battery system performing the method, and an apparatus or system (e.g., vehicle) including the lead-acid battery system.

In a further embodiment, a lead-acid battery system is disclosed. The system includes a cells compartment, a battery monitoring system compartment, a wall positioned between the cells compartment and the battery monitoring system compartment, and a post extending through the wall between the cells compartment and the battery monitoring system compartment, and a sensor coupled to the post. Also disclosed is an apparatus or system (e.g., vehicle) including the lead-acid battery system.

In another embodiment, a lead-acid battery system is disclosed. The lead-acid battery system comprises a housing defining at least in part a cells compartment and at least in part a battery monitoring system (BMS) compartment, and including a wall disposed between the cells compartment and the BMS compartment. The lead-acid battery system further comprises a battery cell housed in the cells compartment. The battery cell has a first post and a second post associated with the battery cell. The first post and the second post protrude through the wall between the cells compartment to the BMS compartment. The lead-acid battery system further comprises a battery monitor system (BMS) housed by the BMS compartment. The BMS includes a voltage sensor electrically coupled to the first post and the second post. Also disclosed is an apparatus or system (e.g., vehicle) including the lead-acid battery system.

In yet another embodiment, a method of monitoring a lead-acid battery comprising a plurality of cells is disclosed. The method further comprises sensing a first temperature of a first one or more cells of the plurality of cells, sensing a second temperature associated with the lead-acid battery, and determining a state of the lead-acid battery based on the first temperature and the second temperature. Also disclosed is a lead-acid battery system performing the method, and an apparatus or system (e.g., vehicle) including the lead-acid battery system.

In a further embodiment, a lead-acid battery system is disclosed. The lead-acid battery system comprises a housing having a first compartment and a second compartment distinct from the first compartment, lead-acid battery cells disposed in a first compartment, a sensor disposed in the second compartment and to sense a stimulus associated with at least one of the lead acid battery cells, and a processor and memory disposed in the second compartment and in communication with the sensor. The memory includes instructions executable by the processor to cause the battery system to monitor a parameter based on the stimulus sensed by the sensor, and determine a state of health, a state of function, or both a state of health and a state of function for the battery system based on the monitored parameter. Also disclosed is an apparatus or system (e.g., vehicle) including the lead-acid battery system.

In another embodiment, a method of responding to a possible fault of a lead-acid battery system for use in an apparatus. The method includes monitoring a cell-level parameter of the lead-acid battery system, comparing a value of the cell-level parameter to a threshold, determining a possible fault based on the comparison, and communicating the possible fault to the apparatus. Also disclosed is a lead-acid battery system performing the method, and an apparatus or system (e.g., vehicle) including the lead-acid battery system.

In yet another embodiment, a method of monitoring for a fault with a lead-acid battery system for use in an automated vehicle. The method includes determining a level of automation for the vehicle for the lead-acid battery system to be placed in, determining a threshold value indicative of a fault based on the level of automation, monitoring a parameter of the battery system, comparing a value of the parameter to the threshold value, and determining a possible fault based on the comparison. Also disclosed is a lead-acid battery system performing the method, and an apparatus or system (e.g., vehicle) including the lead-acid battery system.

In one or more embodiments, the lead-acid type battery system can output information related to the state of the lead-acid battery. The output can be via a display, a wired connection (e.g., a communication port), and/or a wireless connection (e.g., a radio frequency antenna or an infrared transmitter). The display can include a plurality of lights, such as a plurality of light-emitting diodes.

These and other features, advantages, and embodiments of apparatus and methods according to this invention are described in, or are apparent from, the following detailed descriptions of various examples of embodiments.

### BRIEF DESCRIPTION OF THE DRAWINGS

- FIG. 1: is a perspective view of a lead-acid battery.
- FIG. 2: is a perspective view of the lead-acid battery of FIG. 1 with the cover removed.
- FIG. 3: is a partially exploded perspective view of the lead-acid battery of FIG. 1.
- FIG. 4: is a sectional view of the lead-acid battery of FIG. 1 with electrolyte being injected into the battery.
- FIG. 5: is a perspective view of a vehicle having a battery system contributing all or a portion of the power for the vehicle.
- FIG. 6: is a cutaway schematic view of the vehicle of FIG. 5, in the form of a hybrid electric vehicle (HEV).
- FIG. 7: is a perspective view of a lead-acid battery system.
- FIG. 8: is a block diagram of the lead-acid battery system of FIG. 7 having a battery monitoring system.
- FIG. 9: is a block diagram of the battery monitoring system of FIG. 8.
- FIG. 10: is an isometric view of a lead-acid battery system.
- FIG. 11: is an isometric view of the battery system of FIG. 10 with a battery monitoring system (BMS) cover removed.
- FIG. 12: is a top view of the battery system of FIG. 10 with the BMS cover removed.
- FIG. 13: is an isometric view of the battery system of FIG. 10 with the cell housing cover removed.
- FIG. 14: is a partial cross-sectional view of a voltage sense location along the dashed line in FIG. 12.
- FIG. 15: is a more detailed depiction of the process of inserting an O-ring as shown in FIG. 13.
- FIG. 16: is a more detailed depiction of a strap post set with an epoxy, as show in FIG. 12.
- FIG. 17: is a perspective view of a voltage harness that may be used to connect a strap post extending into the BMS housing with the battery monitoring unit of the battery system of FIG. 10.
- FIG. 18: is a perspective view of an example terminal clamp that may be used to connect a terminal extending into the BMS housing with the battery monitoring unit of the battery system of FIG. 10.
- FIG. 19: is a block diagram of the lead-acid battery system of FIG. 10 having a BMS.
- FIG. 20: is a slide showing scenarios and outcomes on how the smart lead-acid battery system of FIG. 7 or FIG. 10 can address the scenarios.
- FIG. 21: is a slide representative of how the Society of Automotive Engineers (SAE) defines six levels of driving automation ranging from zero (fully manual) to five (fully autonomous).
- FIG. 22: is a slide providing some example features for the levels zero to five of FIG. 21.
- FIG. 23: is a table showing example vehicles from vehicles with ICE only to vehicles being electric only and showing example energy demands for each type of vehicle.
- FIG. 24: is slide representing critical provider of power to support xEV vehicle powernet and autonomous systems.
- FIG. 25: is slide representing how 12V advance batteries can be used in xEVs.
- FIG. 26: is a slide disclosing battery strategies for xEV automated vehicles.
- FIG. 27: is a slide providing an example of the importance of battery functionality.
- FIG. 28: is a schematic showing a functional safety scenario for the smart lead-acid battery system of FIG. 7 or FIG. 10 in circuit with a high-voltage traction battery.
- FIG. 29: is a flow chart representing a process for developing the lead-acid battery system as a safety integrity battery.
- FIG. 30: is a flow chart representing a process for an EV drive cycle.
- FIG. 31-33: are tables comparing value propositions between AGM and 12V Li-ion in xEVs.
- FIG. 34: is a slide showing a traditional approach for monitoring a traditional lead-acid battery.
- FIG. 35: is a slide showing alternative means for testing a lead-acid battery, including with the smart lead-acid battery system.
- FIGs. 36 and 37: are slides showing numerous benefits of cell-level monitoring, whether being a group of cells or singular cells.
- FIG. 38: is a slide showing a competitive view of the smart lead-acid battery system versus other battery types.

It should be understood that the drawings are not necessarily to scale. In certain instances, details that are not necessary to the understanding to the invention or render other details difficult to perceive may have been omitted. It should be understood, of course, that the invention is not necessarily limited to the apparatus or processes illustrated herein.

Within the scope of this application, it is expressly intended that the various aspects, embodiments, examples and alternatives set out in the preceding paragraphs, and the claims and/or the following description and drawings, and in particular the individual features thereof, may be taken independently or in any combination. That is, all embodiments and all features of any embodiment can be combined in any way and/or combination, unless such features are incompatible. The applicant reserves the right to change any originally filed claim or file any new claim accordingly, including the right to amend any originally filed claim to depend from and/or incorporate any feature of any other claim although not originally claimed in that manner.

### DETAILED DESCRIPTION

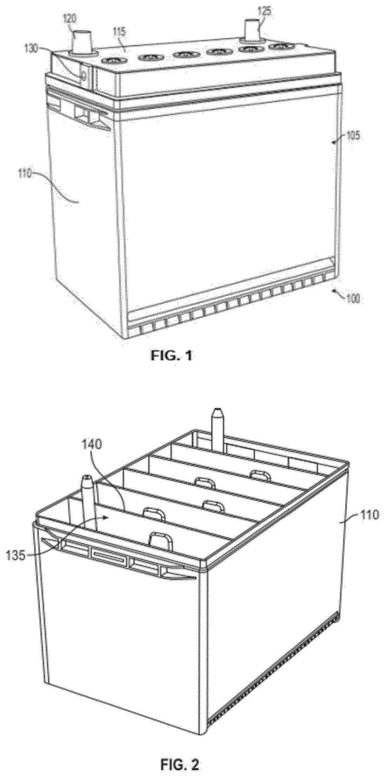

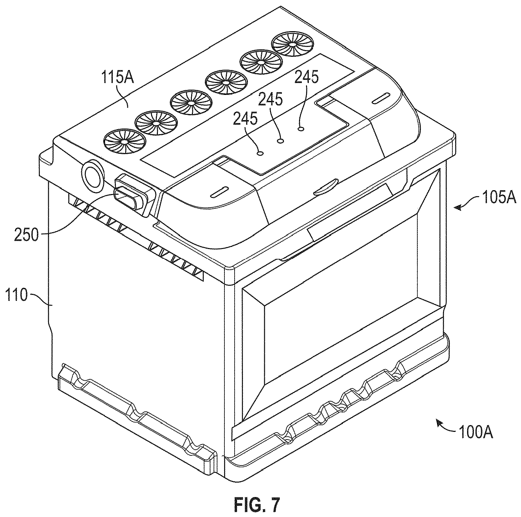

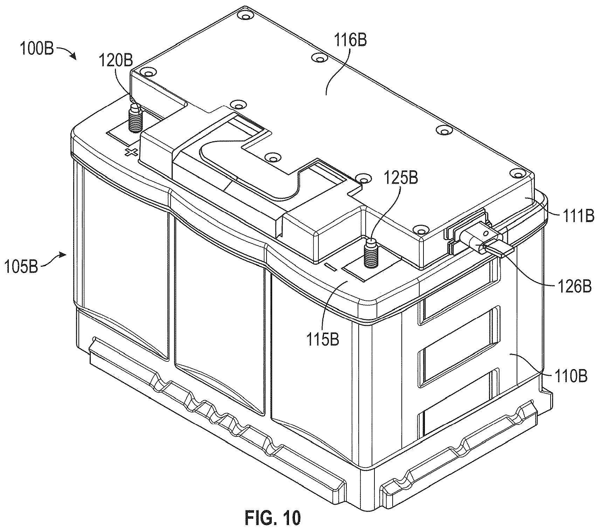

FIGs. 1-4 show an absorbent glass matt (AGM) lead-acid battery 100 having a housing 105. The lead-acid battery 100 can be for use with vehicles. Other example applications that might include a lead-acid battery include, but not limited to, starting, lighting, and ignition batteries; a commercial battery; an industrial battery; a marine battery; etc. The lead-acid battery 100 of FIGs. 1-4 is used for showing some of the underlying elements of a lead-acid battery and for providing background to the apparatus (or systems) and processes (or methods) described herein. It should be understood by one skilled in the art, however, that other styles of AGM lead-acid batteries (e.g., a cylindrical cell-type AGM lead-acid battery, bi-polar AGM battery, AGM batteries with differing cell numbers) and other types of lead-acid batteries (e.g., a non-AGM lead-acid battery, flooded and extended lead-acid battery, gel-type battery) can be used with aspects of the invention. However, for ease of description, the disclosure herein will generally focus on the style of AGM lead-acid battery 100 shown in FIGs 1-4. This includes variations of the AGM lead-acid battery systems 100B and 100C shown in FIGs. 7 and 10.

With reference to FIG. 1, the housing 105 includes a base 110 and a cover 115. The cover 115 is secured to the base 110. An example means of securing is by heat sealing the cover 115 to the base 110 at various points. The battery 100 further includes terminals (or bushings) 120 and 125), and a vent aperture 130 for venting gas from a venting system. The terminals protrude through or on the housing 105 (e.g., the cover 115 as shown). The terminals 120 and 125 are provided on the cover 115 for connecting or coupling the battery 100 to electrical loads. Example electrical loads could include loads of a vehicle electrical system (discussed below).

FIG. 2 shows the cover 115 removed. The battery housing 105 supports a plurality of battery cell compartments (one compartment, 135, is labelled). The cell compartments can be formed by the housing 105 and a plurality of cell walls or partitions (one partition, 140, is labelled) that define the plurality of cell compartments. The partitions may be formed as being unitary with the housing 105. While the construction discussed herein has six cell compartments, a different number of compartments may be provided. Further, while the shown compartments are generally rectangular in shape, other shapes may be used for the compartments. The cell compartments (and related battery cells) may conventionally be referred to by number. For example, a six-cell battery would have cells 1, 2, 3, 4, 5, and 6. According to an example construction in which a battery is provided as having six cells, five partitions are provided.

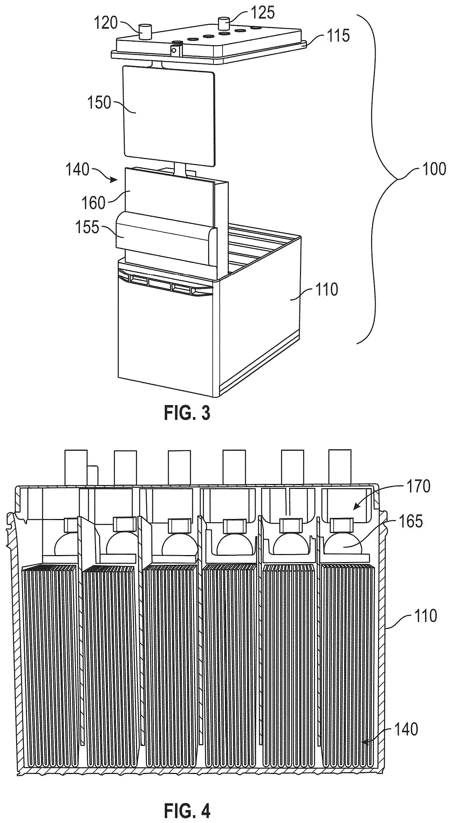

FIG. 3 shows one of a plurality of battery cells in a partially exploded view. The battery cell 140 includes a plurality of positive frames or plates, a plurality of separators partially surrounding the positive plates, and a plurality of negative frames or plates. FIG. 3 has one positive frame or plate 150, one separator 155, and one negative frame or plate 160 labelled.

In some types of lead-acid batteries, the positive and negative plates each comprise a lead or lead-alloy grid that serves as a substrate and supports an electrochemically active material deposited or otherwise provided thereon during manufacture to form the battery plates. The grids provide an electrical contact between the positive and negative active materials or paste which serves to conduct current.

Separators are provided between the plates to prevent shorting and/or undesirable electron flow produced during the reaction occurring in the battery 100. Positive and negative electrode plates can be classified into various types according to the method of manufacturing. In one or more examples, each frame has a generally rectangular shape and includes a lug which is electrically coupled to the battery terminals 120 and 125. The frame also may include side walls, a bottom edge, and opposing faces.

The one or more battery separators are used to insulatively separate the positive and negative electrodes. A separator material for an AGM lead-acid battery has sufficient porosity and retention to contain at least substantially all of the electrolyte necessary to support the electrochemical reactions. In various examples, the separator material is compressible so that upon stacking of the elements, the separator material substantially conforms to the contour of the surface of the plates to help it perform its wicking or capillary action. FIG. 4 shows electrolyte 165 being poured into the battery cells through pour holes. Pour hole 170 is labelled in FIG. 4.

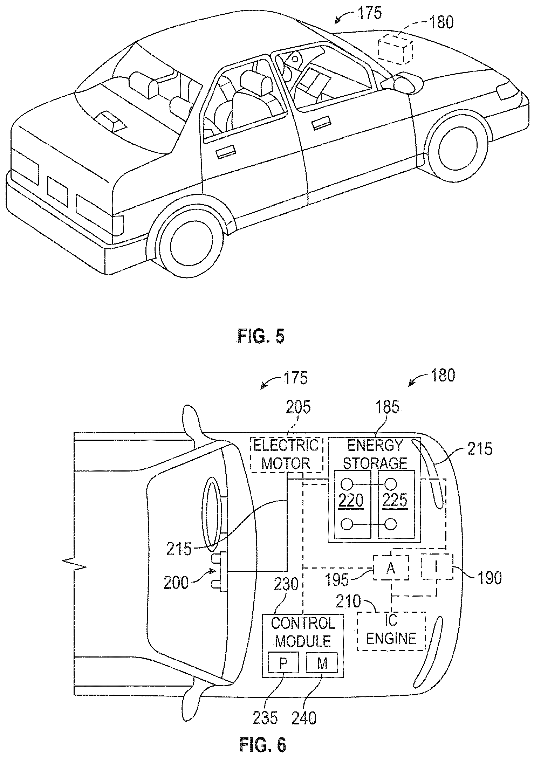

FIG. 5 is a perspective view of a vehicle 175 having a battery system (represented by block 180). A vehicle (e.g., a petrol or gasoline vehicle, an electric vehicle, a hybrid vehicle) uses one or more batteries or battery systems. As will be appreciated by those skilled in the art, hybrid electric vehicles (HEVs) combine an internal combustion engine (ICE) propulsion system and a battery-powered electric propulsion system, such as 48 Volt (V) or 130V systems. Plug-in HEVs (PHEVs) are HEVs that can be plugged in to help charge the batteries. Electric vehicles (EVs) are vehicles with no ICE. Each of these hybrid or full electric vehicles can be classified using the acronym xEV.

A more detailed block diagram for the battery system 180 is described in FIG. 6. As depicted, the battery system 180 includes an energy storage component 185. The energy storage component is coupled to an ignition system 190, an alternator 195, a vehicle console 200, and an electric motor/generator 205. Generally, the energy storage component 185 may capture/store electrical energy generated in the vehicle 175 and output electrical energy to power electrical devices in the vehicle 175.

The battery system 180 may supply power to components of the vehicle's electrical system. Example electrical loads for the electrical system can include, but not limited to, radiator cooling fans, climate control systems, electric power steering systems, active suspension systems, auto park systems, electric oil pumps, electric super/turbochargers, electric water pumps, heated windscreen/defrosters, window lift motors, vanity lights, tire pressure monitoring systems, sunroof motor controls, power seats, alarm systems, infotainment systems, navigation features, lane departure warning systems, electric parking brakes, external lights, or any combination thereof. In the depicted construction, the energy storage component 185 supplies power to the vehicle console 200, the ignition system 190, and the electric motor/generator 205. The ignition system may be used to start (e.g., crank) the internal combustion engine 210.

Additionally, the energy storage component 185 may capture electrical energy generated by the alternator 195 and/or the electric generator 205 when acting in a generation state. In some implementations, the alternator 195 generates electrical energy while the internal combustion engine 210 is running. Additionally or alternatively, the electric generator 205 can generate electrical energy by converting mechanical energy produced by the movement of the vehicle 175 (e.g., rotation of the wheels) into electrical energy. Thus, the energy storage component 185 may capture electrical energy generated by the electric motor/generator 205 during regenerative braking.

To facilitate capturing and supplying electric energy, the energy storage component 185 may be electrically coupled to the vehicle's electric system via a bus 215. For example, the bus 215 enables the energy storage component 185 to receive electrical energy generated by the alternator 195 and/or the electric generator 205. Additionally, the bus 215 may enable the energy storage component 185 to output electrical energy to the ignition system 216, the vehicle console 220, and/or the electric motor 205.

Additionally, as depicted, the energy storage component 185 includes multiple batteries and/or battery systems. For example, in the depicted embodiment, the energy storage component 185 includes a lithium-ion (e.g., a first) battery system 220 and a lead-acid (e.g., a second) battery system 225. In other constructions, the energy storage component 185 includes any number of battery systems. Additionally, although the lithium-ion battery system 220 and lead-acid battery system 225 are depicted adjacent to one another, they may be positioned in different areas around the vehicle 175. For example, the lithium-ion battery system 220 may be positioned about or beneath the interior of the vehicle 175 while the lead-acid battery system 225 may be positioned under the hood of the vehicle 175.

To facilitate controlling the capturing and storing of electrical energy, the battery system 180 additionally includes a control module 230. More specifically, the control module 230 may control operations of components in the battery system 180. Example components controlled by the control module 230 include relays and/or switches within the energy storage component 185, the alternator 195, and/or the electric motor/generator 205. The control module 230 may, among other things, regulate the amount of electrical energy captured/supplied by each battery system 220 or 225 (e.g., to de-rate and re-rate the battery system 180), perform load balancing between the battery systems 220 and 225, determine a state of charge of each battery 220 or 225, control voltage output by the alternator 195 and/or the electric motor 205, and the like. The control module 230 may be part of a vehicle control module. As shown in FIG. 6, the control module 230 includes one or more processors 235 and one or more memories 236. Example processors and memories will be discussed below in connection with the lead-acid battery system 100A.

The electric motor/generator 205, alternator 195, ignition system 190, and ICE 210 are all shown in FIG. 6 in phantom because which component is present in the vehicle 175 is dependent upon the type of vehicle 175. For example, an electric-only vehicle will not include the alternator 195, ignition system 190, and ICE 210. An ICE-only vehicle will not include the electric motor/generator 205. A hybrid-electric vehicle may include all of the electric motor/generator 205, alternator 195, ignition system 190, and ICE 210. Other variations are possible.

The battery systems 220 and 225 described herein may be used to provide power to various types of vehicles (e.g., xEVs). The battery systems 220 and 225 described herein may also be used to provide power to other energy storage/expending applications. One skilled in the art of battery technologies will be able to extend the invention(s) and aspects of the invention(s) to other energy storage/expending applications, including other stationary and nonstationary contexts. The invention(s) and aspects of the invention(s) can be used to address distinct functions of different applications. The invention(s) and aspects of the invention(s) are applicable to vehicle applications, including for example without limitation, automotive, bus, light and heavy duty trucks, marine and recreational vehicles, with the function of moving people or cargo having a primary concern of engine start and load support. Additionally, the invention(s) and aspects of the invention(s) are applicable to motive applications, including for example without limitation, forklifts, golf carts and industrial functions directed to moving people or materials with battery as primary power supply. Furthermore, invention(s) and aspects of the invention(s) are applicable to reserve applications, including for example without limitation, stationary uninterruptable power supply systems, telecom, grid and renewable functions directed to battery supporting applications in power outage and to balance power supply and demand. For ease of explanation, the energy storage/expending application focused on herein is the vehicle 175.

FIG. 7 shows a "smart" lead-acid battery system 100A substantially similar to the lead-acid battery 100. The lead-acid battery system 100A has a housing 105A. The housing 105A includes a base 110 and a cover 115A. The cover 115A is secured to the base 110. Unlike cover 115, the cover 115A includes three light indicators 245 (e.g., light-emitting diodes (LEDs)) integrated with or on the cover 115A and a communication port (or connector) 250 in or through the cover 115A.

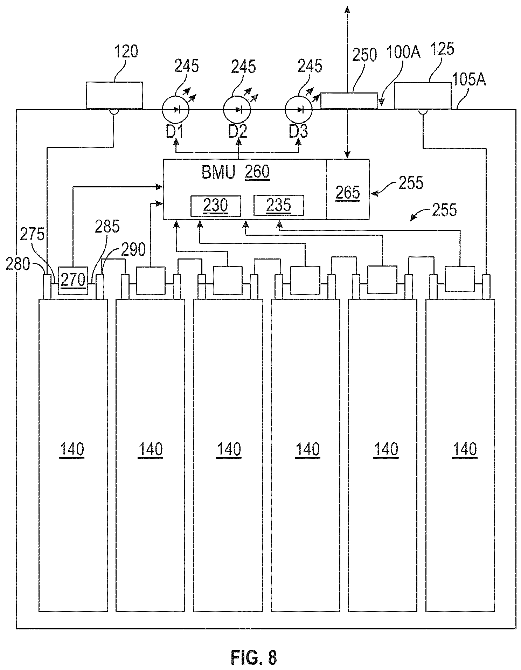

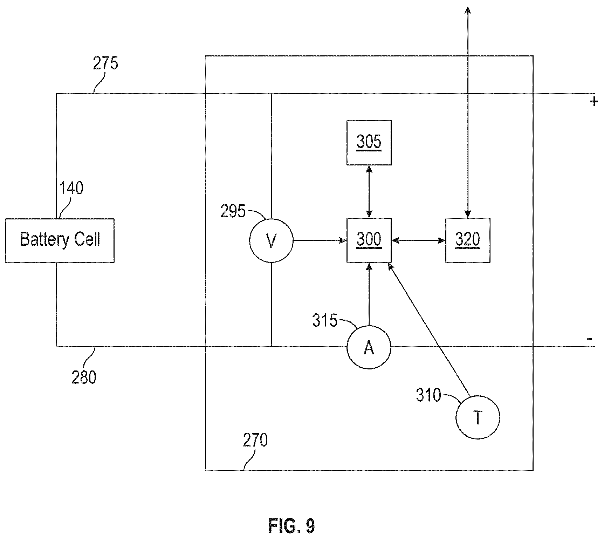

FIGs. 8 and 9 schematically shows the battery system 100A having a lead-acid battery, such as the AGM battery of FIGs. 1-4 with a battery monitoring system (BMS). FIG. 8 is a block diagram of the battery 100A having an integrated BMS 255. The integrated BMS 255 is disposed within the battery housing 105A. The battery cells (or battery) with the BMS 255 results in the battery system 100A. It is envisioned in certain constructions that the BMS 255 may be at least partially located outside from the battery housing 115A (e.g., within a separate housing attached to the battery housing 115A). It is also envisioned that aspects of the BMS 255 may be combined with another element of the larger system the battery 100 is part of.

The battery system 100A includes an array of battery cells (which are schematically represented as 140) connected in series. A battery monitoring unit 260 includes a communication module 265 configured to receive and/or transmit signals to/from external devices. The communication may be via a wired connection, as shown. In other constructions, the battery monitoring unit 260 may include a communication module 265 that has a transmitter and antenna capable of communicating through radio frequency signals, such as via a point-to-point connection (e.g., a Bluetooth connection), a wireless local area network connection (e.g., a Wi-Fi or ZigBee connection), a cell phone data connection (e.g., code division multiple access), or other suitable connection.

In the illustration of FIG. 8, a measurement device 270 includes one or more sensors configured to monitor an operational parameter of a related battery cell and is configured to output a signal indicative of the operational parameter to the battery monitoring unit 18. The communication from the measurement device 270 to the battery monitoring unit may be performed via a wired connection as shown. It is also envisioned that the communication from the measurement device can be via a wireless communication. It is also envisioned that a transmitter is communicatively coupled with the measurement device 270 and configured to output the signal indicative of the operational parameter via modulation of a power signal output by the related battery cell 140. Other arrangements for the measurement device 270 will be discussed below.

As illustrated in FIG. 8, each measurement device 270 includes a first lead 275 coupled to the positive lugs 280 of a respective battery cell 140, and a second lead 285 coupled to the negative lug 290 of the battery cell 140. Only one cell is labelled with respect to reference numbers 275-290. Each measurement device 270 can include a sensor (e.g., a voltage sensor), which may be coupled to the first and second leads 275 and 280 and configured to measure a parameter of the power (e.g., a voltage). Although the illustrated construction includes one self-contained measurement device 270 for each cell 140, some constructions may include more or less measurement devices 270. For example, it is envisioned that the battery measurement devices 270 can be configured to monitor parameters for multiple cells 140.

FIG. 9 provides a further schematic diagram of an example of a measurement device 270. As illustrated, the measurement device 270 includes a voltage sensor 295 electrically coupled to the first lead 275 and the second lead 285. Because the first lead 275 is electrically connected to the positive lug 280 and the second lead 285 is electrically connected to the negative lug 290, the voltage sensor 295 senses the voltage across the battery cell 140. The voltage sensor 295 can be coupled to a processor 300 and a memory 305. The processor 300 receives a signal from the voltage sensor 295 indicative of the cell voltage, and to determine the cell voltage based on the signal. For example, in certain embodiments, the voltage sensor 295 may output an analog signal proportional to the sensed voltage. In such implementations, the processor 300 may be configured to convert the analog signal into a digital signal, and to determine the voltage based on the digital signal. The memory 305 may be configured to store battery cell identification information, operational parameter history information, battery cell type information, and/or usage information. For example, a unique identification number may be associated with each battery cell 140 and stored within the memory 305. Alternatively, the voltage sensor 295 can provide the analog signal to a processor and memory, discussed below, of the battery monitoring unit 260.

The measurement device 270 can include other sensors, such as a temperature sensor 310. The temperature sensor 310 outputs a signal indicative of the battery cell temperature. For example, in certain embodiments, the temperature sensor 310 may output an analog signal proportional to a measured temperature. It should also be appreciated that alternative constructions may include additional sensors configured to monitor other operational parameters of the battery cell 140. For example, the measurement device 270 may include a sensor configured to measure the state of charge within the battery cell 140, a current sensor 315 configured to determine a current being provided by the cell 140, a pressure sensor configured to detect an excessive pressure within the cell 140, an acid density measurement to measure acid density in a cell 140, and/or other sensors configured to monitor an electrical, physical, or chemical parameter of the battery cell 140.

As illustrated, the measurement device 270 includes processor 300, a memory 305, and a transceiver 320. The transceiver 320 may be configured to receive wired and/or wireless signals external sources. It is contemplated that the processor 300 and memory 305 may each be a single electronic device or formed from multiple devices.

The processor 300 can include a component or group of components that are configured to execute, implement, and/or perform any of the processes or functions described herein for the measurement device 270 or a form of instructions to carry out such processes or cause such processes to be performed. Examples of suitable processors include a microprocessor, a microcontroller, and other circuitry that can execute software. Further examples of suitable processors include, but are not limited to, a core processor, a central processing unit (CPU), a graphical processing unit (GPU), an array processor, a vector processor, a digital signal processor (DSP), a field-programmable gate array (FPGA), a programmable logic array (PLA), an application specific integrated circuit (ASIC), math co-processors, and programmable logic circuitry. The processor 300 can include a hardware circuit (e.g., an integrated circuit) configured to carry out instructions. In arrangements in which there are a plurality of processors, such processors can work independently from each other, or one or more processors can work in combination with each other.

The memory 305 includes memory for storing one or more types of instructions and/or data. The memory 305 can include volatile and/or non-volatile memory. Examples of suitable memory include RAM (Random Access Memory), flash memory, ROM (Read Only Memory), PROM (Programmable Read-Only Memory), EPROM (Erasable Programmable Read-Only Memory), EEPROM (Electrically Erasable Programmable Read-Only Memory), registers, disks, drives, or any other suitable storage medium, or any combination thereof. The memory 305 can be a component of the processor 300, can be operatively connected to the processor 300 for use thereby, or a combination of both.

In one or more arrangements, the memory 305 can include various instructions stored thereon. For example, the memory 305 can store one or more software modules. The software modules can be or include computer-readable instructions that, when executed by the processor 300, cause the processor 300 to perform the various functions disclosed for the measurement device 270. While functions may be described herein for purposes of brevity, it is noted that the functions for the measurement device 270 are performed by the processor 300 using the instructions stored on or included in the various modules. Some modules may be stored remotely and accessible by the processor 300 using, for instance, various communication devices and protocols.

The battery monitoring unit 260 can also include a processor 300A and a memory 305A similar to the processor 300 and memory 305. The memory 305A of the battery monitoring unit 260 may also be configured to store battery identification information, battery operational parameter history information, battery type information, and/or battery usage information. The memory 305A may be further configured to store, for each cell 140, battery cell identification information, battery cell operational parameter history information, battery cell type information, and/or battery cell usage information. For example, a unique identification number may be associated with each battery cell 140 and stored within the memory 305A. In such a configuration, the battery monitoring unit may identify a particular battery cell 140 based on the unique identification number, thereby providing more context to the measured parameters of the between the measurement device 270. The memory 305A may also be configured to store historical values of measured operational parameters of the battery system 100A and the battery cells 170. For example, the memory 305A may store the maximum and/or minimum voltage measured by a voltage sensor 295. Such information may be useful for diagnosing faults within a battery cell 14, as will be discussed in some of the further constructions below. Furthermore, the memory 305A may be configured to store usage information, such as average load, maximum load, duration of operation, or other parameters that may be useful for monitoring the operational status of the battery system 100A and/ battery cells 140. Similar information may be stored in the battery monitoring unit 260 for combinations of battery cells 140 (e.g., cells 1-3 and cells 4-6).

Before moving to other components, it should be understood by somebody skilled in the art that the battery monitoring unit may include additional conventional elements typically found in a battery or a monitoring unit. Further discussion regarding these components is not provided herein since the components are conventional and their operation are conventional.

Referring again to FIGs. 7 and 8, the battery system includes a display. The shown display includes three light indicators 245. More specifically, the three light indicators 245 are shown as three light emitting diodes (LEDs). The three LEDs can provide information to a user (e.g., owner of the battery) in alternative to or in combination with the wired and wireless communication from the battery. Other displays can be used in alternative to the light indicators 245.

The battery system also includes a communication (or connector) port 250 for connecting a communication cable to the battery housing 105A. The communication cable can promote communication between the battery system 100A and an external apparatus, such as a vehicle control module if the battery system 100A is used in a vehicle.

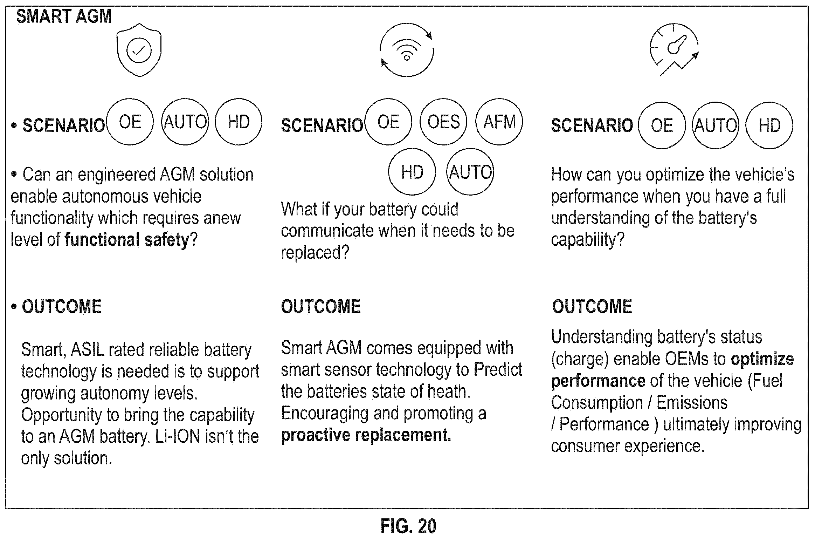

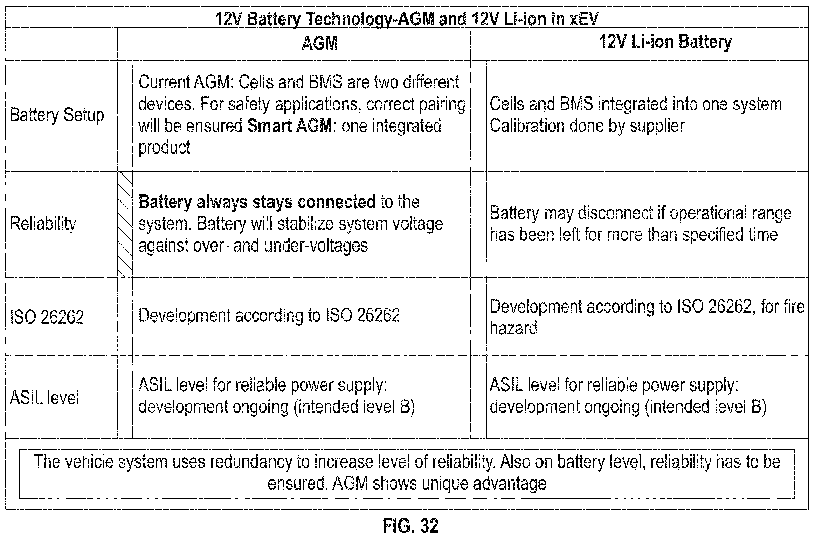

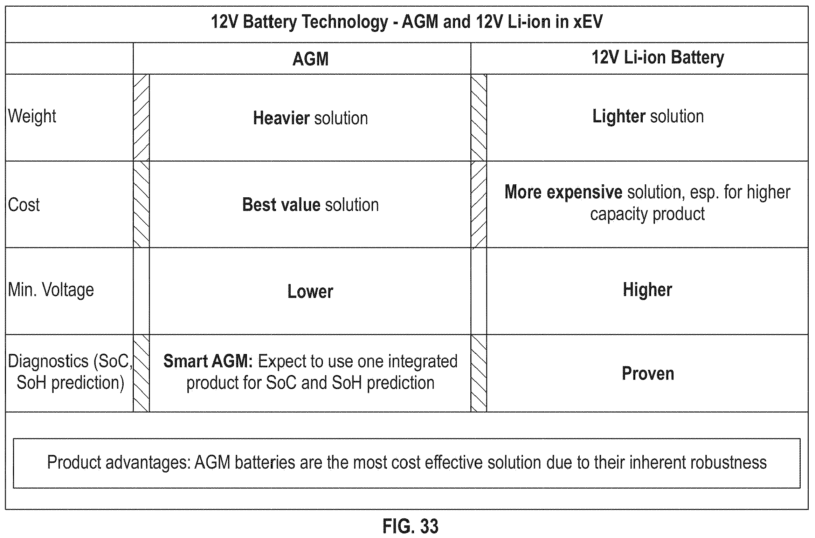

During one operation of the battery system 100A, each measurement device 270 monitors a cell voltage of each respective cell 140 the measuring device 270 is associated with. Each measurement device 270 can monitor other parameters associated with the respective cell 140 if the measurement device 270 includes other sensors as discussed above. Analog value(s) or processed value(s) can be provided to the battery monitoring unit 260. The battery monitoring unit 260 can separately monitor other parameters of the lead-acid battery system 100A, such as a total battery voltage, various combinations of battery cell voltages, a total battery current, a total battery charge, etc. Based on the acquired parameters and related values, the battery monitoring unit 260 can determine a state of health of the lead-acid battery system 100A, particularly the battery and battery cells. Further based on the acquired parameters and related values, the battery monitoring unit 260 can determine a state of function of the lead-acid battery system (e.g., readiness in terms of usable energy by observing state-of-charge in relation to the available capacity), particularly the battery and battery cells. This is more information than previously available for known lead-acid batteries. For example, a total battery voltage of a prior lead-acid battery may be monitored by the vehicle control unit, and which may be within a safety range. However, by monitoring cell voltage, the battery monitoring unit 260 can identify a potentially faulty cell, thereby identifying a possible issue for the lead-acid battery system 100A sooner than the vehicle control unit can identify a possible issue through the total battery voltage. The lead-acid battery system 100A herein can also provide better prediction capabilities using the additional voltage information related to the individual cells 140. By extension, this applies to the other possible cell parameters (discussed above) sensed by the measurement devices 270 and the battery monitoring unit 260. Further and more detailed operation examples are provided below with FIGs. 20-38.

The lead-acid battery system 100A can also store the information for further analysis over time or the stored information can be later analyzed and mined as part of a battery recycling process. For example, detailed usage information associated with the lead-acid battery system 100A and associated with the individual cells 140 can be saved, recalled, and compared to the final cell state upon recycling. Again, further and more detailed operation examples are provided below with FIGs. 20-38.

The communication from the lead-acid battery system 100A can be done through different ways. The battery system 100A can include a display. One display in FIG. 7 is shown as three single LEDs. The inclusion of the LEDs can provide eight different states through the use of three-bits of information. The inclusion of flashing and multiple color can grow the number of states that can be communicated. This allows a user/owner or mechanic to receive information and states upon simply looking at the lead-acid battery system 100A.

The information related to the lead-acid battery system 100A and the state of the lead-acid battery can also be communicated through a wire connection and/or through wireless communication. For example, information may be communicated to the vehicle control module, which can provide information to the driver via the indicator panel 220. Alternatively, an analysis tool can be coupled (either wireless or direct connection) to the lead-acid battery system 100A for communicating with the battery monitoring unit 260, and more specifically obtain information from the memory 305A.

FIGS. 10-15 show a second lead-acid battery system 100B with a housing 105B. Like battery system 100A, the battery system 100B can be used with vehicles or non-vehicle other applications.

With reference to FIG. 10, the housing 105B includes a battery cell base 110B and a battery cell cover 115B. The cell cover 115B is secured to the cell base 110B. The housing 105B further includes a battery management system (BMS) base 111B and a BMS cover 116B. The BMS cover 116B is secured to the BMS base 111B, for example, by heat sealing the cover to the battery at various points. Alternatively, the BMS cover 116B is connected to the BMS base 111B using a number of fasteners 118 (e.g., screws, bolts). For the embodiment shown, the BMS base 111B is integrally formed with the cell cover 115B. The battery further includes terminals (or bushings) 120B and 125B protruding through or on the housing (e.g., the cell cover as shown). The terminals 120B and 125B are provided on the cover for connecting or coupling the battery to electrical loads (e.g., a vehicle electrical system). A communication connecter 126B (e.g., a vehicle communication connector) protrudes through or on the BMS base 111B. In the illustrated example, the communication connector protrudes through a side wall of the BMS base 111B. Alternatively, it may pass through the top or cover of the housing 105.

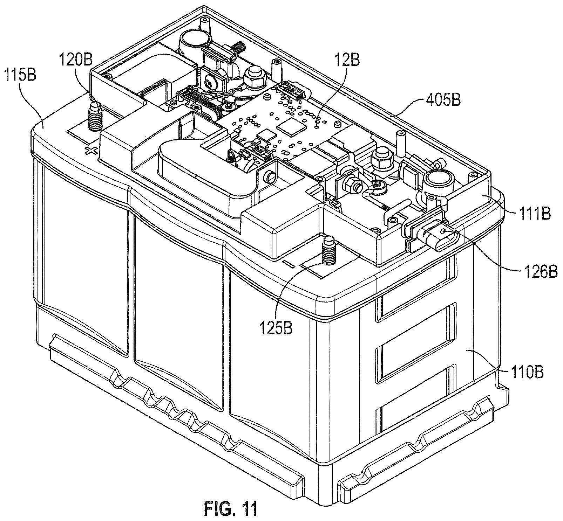

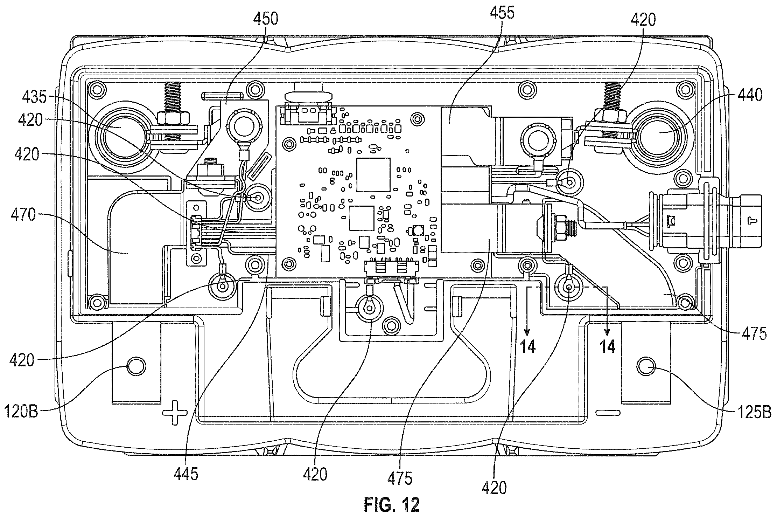

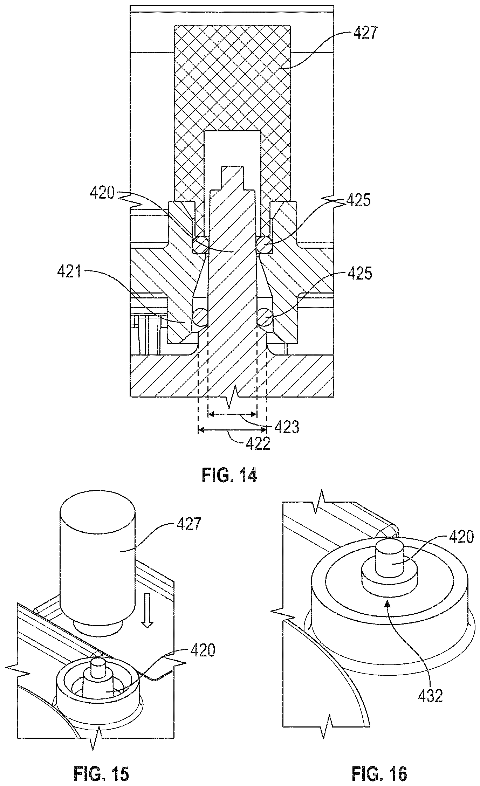

FIGS. 11 and 12 show the example BMS cover 116B removed. FIG. 14 shows the cell cover 115B removed. The cell base 110B supports a plurality of battery cell compartments (one compartment 135B is labelled). The cell compartments 135B can be formed by the cell base 110B and a plurality of cell walls or partitions (one wall 140B is labelled) that define the plurality of cell compartments 135B. The partitions 140B may be formed as being unitary with the housing 105B. While the construction discussed herein has six cell compartments 135B, a different number of compartments may be provided. Further, while the shown compartments 135B are a generally rectangular shape, other shapes may be used for the compartments. The cell compartments 135B (and related battery cells) may conventionally be referred to by number (e.g., 1, 2, 3, 4, 5, 6, etc.).

The battery cells 140B include a plurality of positive frames or plates, a plurality of separators partially surrounding the positive plates, and a plurality of negative frames or plates. The design and implementation of the battery cells 140B can be similar to what was discussed above with the battery 100, which is incorporated here.

Also similar to what was described for battery system 100A, the battery system 100B is a "smart" battery system. The arrangement of the "intelligence" for the battery system 100B can be conceptually similar to what was shown in FIGs. 8 and 9 but modified as discussed below. More specifically, the measurement devices 270 shown in FIG. 8 are placed in the base 110, and specifically in the cell compartment(s) 135. The battery system 100B, on the other hand, includes a two-compartment system: battery cells compartment 400B and a BMS compartment 405. One more measurement devices 270B can be placed in the BMS compartment 405. Alternative constructions for this arrangement will be described below.

The battery housing 105B, including the cell base 110B, cell cover 115B, BMS base 111B, and BMS cover 116B, may be made of any polymeric (e.g., polyethylene, polypropylene, a polypropylene containing material, etc.), acryl butyl stearate (ABS), polycarbonate, or composite (e.g., glass-reinforced polymer) material. For example, the housing 105B may be made of polypropylene-containing material (e.g., pure polypropylene, co-polymers comprising polypropylene, polypropylene with additives, etc.). Such polymeric material is relatively resistant to degradation caused by acid (e.g., sulfuric acid) provided within cells of the container. Further, and as will be discussed in more detail, a wall, which is part of the housing 105B, between the cells compartment 400 and the BMS compartment 405, is also resistant to degradation caused by acid provided within the cells compartment 400.

The battery cells compartment 400 includes battery straps 410 coupling one cell to the next, creating the battery voltage. Example battery straps include the battery straps 410, as modified herein, shown and described in US Publication No. 2019/0393473, which is hereby incorporated herein by reference.

The battery straps 410, according to various constructions, connect a number of battery cells 140B, for example, six battery cells, in series. The battery straps 410 may be, according to numerous examples of embodiments, direct path cast-on straps. The battery cells 140B may be comprised of flat-plates, similar to plates 150 and 160 above, stacked together. Each plate may have a respective lug extending out of the top of the grid. The straps 410 may be understood to connect the lugs of the grids in the cells 140B together.

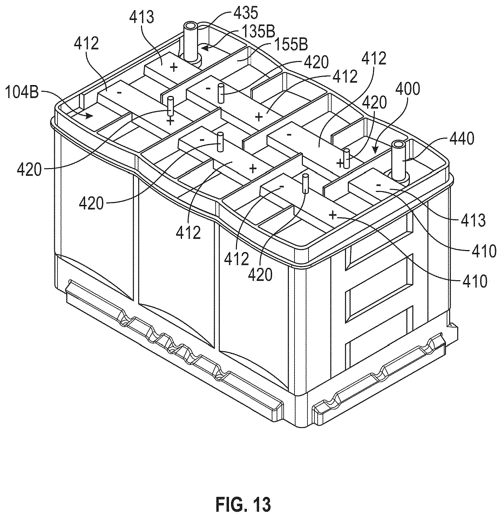

The battery straps 410 may comprise connecting straps 412 and further comprise end straps 413. Five connecting straps 412 are shown in FIG. 13 as coupling six battery elements in series. A positive terminal 120B and a negative terminal 125B integrated into end straps 413 are shown on one side of the battery system 100B in the illustrated example. Connecting straps 412 can be seen connecting the lugs 411 of a first polarity of battery plates of a battery cell to the lugs 411 of the battery plates of an opposite polarity of a second battery cell. A terminal post 120B connected to an end strap 413 having a polarity (e.g., a positive terminal) which connects the lugs of plates of the same polarity (e.g., positive) of a battery cell 140B. Similarly, another terminal post 125B (e.g., a negative terminal) connected to an end strap 413 which connects the lugs 411 of plates (e.g., negative plates) of a battery cell 140B. For the shown construction, this provides all six cells to be connected in series to result in the battery voltage for the battery system 100B. Other series and parallel battery cell arrangements are possible for the battery system 100B as is known in the art to provide different and/or multiple voltages.

Five of the connecting straps 410 can be approximately equal in shape. Similarly, the end straps 411 with the terminals may be approximately equally shaped. The connecting straps 410, in various embodiments, may be substantially rectangular shaped when viewed from above. The connecting straps 410 may be, in various embodiments, substantially a rectangular prism shape, although other shapes are possible.

In various embodiments, a terminal post and end strap 411 may be seen, the terminal post protruding through the battery cover 105. The terminal posts, side terminals, and connection members may be made of one or more conductive materials (e.g., lead or a material containing lead). Likewise, the strap members and end straps may be made of one or more conductive materials (e.g., lead or a material containing lead).

The strap members may be comprised, in various embodiments, of a lead alloy. In various embodiments, this alloy may be a substantially pure lead and may, in various embodiments, include lead, tin, antimony, calcium, and combinations thereof. The alloy, as a non-limiting example, may be a lead-tin alloy with a tin composition range of 1-4%, 1-2.25%, 1-1.5%, and the like. The lead may be virgin lead or high purity lead or highly purified secondary lead, in numerous examples of embodiments.

Each battery strap 410 includes strap posts (e.g., pins, mini posts, protrusions) 420 that are coupled to (e.g., integrated (including cast directly on the strap), welded onto the strap, etc.) with the battery strap. Alternatively, posts or pins or bushings may be coupled to the cover and positioned to be in contact with the straps 410 either directly or indirectly. As used herein, the term post encompasses posts, pins, bushings, and similar structures known to one of ordinary skill in the art. The strap posts 420 protrude through the cell cover/BMS base 115B/111B into the BMS compartment 405 (see FIG. 14). For example, each strap post may be in communication with a measurement device 270 to measure a voltage of each battery cell and/or subset of battery cells. The cell cover/BMS base 115B/111B in the BMS compartment 405 can be a unitary wall 430. The unitary wall 430, at the locations of the strap posts 420, can includes a triple seal of upper and lower O-rings 425 (see FIG. 14) and upper resin seal.

While the strap posts 420 are substantially cylindrical, the strap posts 420 may have a stepped profile, such as that shown in FIG. 14. The stepped profile may include one or more stepped sections; three sections 421A, 421B, and 421C are shown in FIG. 14. In the illustrated example, a taper section 422 exists between the first section 421A and the second section 421B. As shown in FIG. 14, one or more of the O-rings may be pressed into place using an O-ring tool 427. FIG. 14 shows two O-rings 425A and 425B

FIG. 15 depicts a representation of how the O-ring tool 427 may be used to secure an O-ring 425B in place around the strap post. After the O-ring 425B in place, the area around the top of the strap post 420 may be filled in with an epoxy 432 (e.g., a quickset epoxy) to create an additional layer of seal between the inside of the battery housing and the BMS compartment to prevent leaks from the battery housing into the BMS compartment. FIG. 16 is a more detailed view of the epoxy 432 surrounding the strap post 420. Before proceeding, it is envisioned that alternative manufacturing techniques may be used with regard to sealing the BMS compartment 405 from the cells compartment 400. For example, one technique, without limitation, may include the strap posts being sealed as lead post bushings molded into the cover 115B.

The inclusion of the two-compartment system, the strap posts 420, O-rings 425A and 425B, and the epoxy seals 430 prevent acid from escaping the cells compartment 400 and exposing electronics or electrical components to the acid/electrolyte. Accordingly, the electrical or electronic components of the smart lead-acid battery system 100B do not need to be protected for acid exposure like the lead-acid battery 100 or lead-acid battery system 100A would need to be.

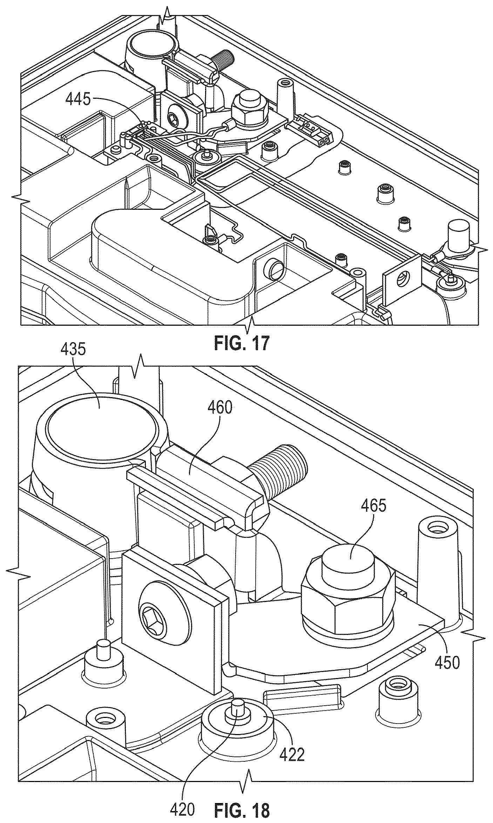

Referring now to FIGs. 17, the example strap posts 420 are each in communication with the battery monitoring unit 260B (or a circuit board of the battery monitoring unit 260B) using flexible connectors 445, which may be referred to as a spider connector. Additionally, the BMS includes further connectors or bus bars (bus bar 450 is labelled in FIG. 17) between each of the battery terminals 435, 440, and the battery monitoring unit 260B. These connectors are coupled to the terminals 435, 440 using a terminal clamp (clamp 460 is labelled in FIG. 17) that is secured to the terminal 435 and coupled to the bus bar 450 using one or more fastener 465 (such as a bolt) as shown in FIGs. 17 and 18. The terminals 435, 440 may be surrounded by multiple O-rings and/or epoxy to create a seal similar to the seal around the strap posts. This connection may allow the BMS to measure an overall voltage and/or current of the battery. The terminals extending into the BMS compartment may be made of lead to facilitate transfer of energy. A second bus bar 455 is shown in FIG. 12.

Second connectors 470, 475 (FIG. 12) are positioned between the BMS and the terminals 120B, 125B that extend to the exterior of the battery housing. The terminals 120B, 125B are the terminals to which a vehicle may be connected. In some examples, the BMS may also obtain voltage and/or current measurements using these terminals. The terminals exposed to the exterior of the battery are in communication with the terminal 435, 440 (FIG. 13) extending into the BMS compartment using one or more of the bus bars and/or second connectors. The terminals exposed to the exterior of the battery may not contain lead.

The BMS compartment 405 (of FIGs. 11 and 12) includes a battery monitoring system (BMS) 255B. The BMS 255B includes a communication module 265 configured to receive and/or transmit signals from external devices, such as a vehicle via the communication port/connector 250B. For example, the communication connector 250B may be connected to the BMS 255B using a flexible harness or a plurality of flexible wires. For the BMS 255B, the BMS 255B includes voltage sensors for measuring cell voltages, a voltage sensor for measuring a battery voltage, a current sensor for measuring a battery current, one or more temperature sensors for measuring various temperatures (e.g., compartment temperature 310A, cell temperature 310B, environment temperature 310C), a BMS microprocessor, and a BMS memory. Discussion of the functionality of the BMS components can be similar to what was discussed above or discussed below.

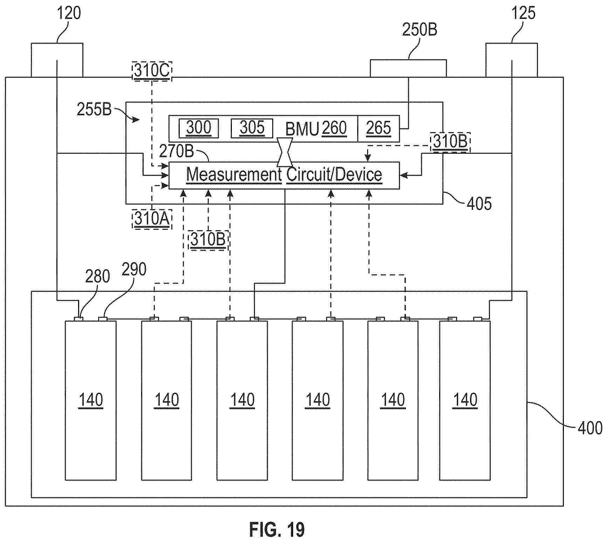

FIG. 19 is a block diagram for one implementation of the smart lead-acid battery system 100B of FIGs. 9-17. The lead-acid battery system 100B of FIG. 18 has an integrated battery monitoring system (BMS) 255B disposed within the BMS compartment 405, thereby resulting in a battery system. In one or more alternative implementations, the battery monitoring system 255B may be partially or fully located remote from the battery system 100B. For example, the BMS may be located in a remote separate housing.

As shown in FIG. 19, the battery system 100B includes an array of battery cells (which are schematically represented as 140) connected to the BMS unit 255B. BMS unit 255B includes a communication module 265 configured to receive and/or transmit signals from external devices (e.g., a vehicle). For example, certain constructions of the battery monitoring system 255B may include a communication module 265 that includes a transmitter capable of communicating through radio frequency signals, such as via a Bluetooth connection, a wireless local area network connection, a cell phone data connection (e.g., code division multiple access), or other suitable connection. The communication module 265 can alternatively or additionally use a wired-communication scheme. Example wired communication standards include controller area network (CAN), local interconnect network (LIN), on-board diagnostic (e.g., OBD-II), recommended standard (e.g., RS-485), etc.

In the illustration, the BMS 255 includes a battery measurement device/circuit 270B. The battery measurement device/circuit 270B includes one or more sensors configured to monitor the battery cells 140B and is configured to output a signal indicative of parameters (e.g., cell voltages) to the battery monitoring unit 260B. As illustrated, leads are coupled to various terminals (or lugs). Depending on the attached leads, the measurement device 270B can acquire individual cell voltages, group cell voltages, and/or battery voltages for the battery system 100B. For the shown example, the measurement device 270B is located in the BMS compartment 405 and not the cells compartment 400.

For battery system 100B, the measurement device 270B can include voltage sensors (e.g., voltmeters) electrically coupled to the various leads provided to the measurement device 270B. The voltage sensors can be communicatively coupled to a processor 300B and memory 305B, such as a processor and memory similar to processor 300 and memory 305 discussed above. It should be appreciated that the battery system 100B includes additional sensors configured to monitor other operational parameters of the battery cells 140B and or the battery system 100B, similar to what was described earlier for the measurement devices 270 and battery monitoring unit 260. The measurement device 270B can also include circuitry in communication with temperature sensors 310A, 310B, and 310C (e.g., thermistors) electrically coupled to the the measurement device 270B. The temperature sensors can be communicatively coupled to a processor 300B and memory 305B, such as a processor and memory similar to processor 300 and memory 305 discussed above.

One environment for the smart battery systems 100A and 100B are automated vehicles (AV). AVs combine a variety of sensors to perceive their surroundings. Example sensors include radar, lidar, sonar, GPS, odometry, and inertial measurement units. Advanced control systems interpret sensory information to identify appropriate vehicle actions. A truly autonomous vehicle is a self-governing vehicle. FIGs. 20-38 relate, at least in part, to a discussion for a "smart" lead-acid battery system (e.g., the battery systems 100A and 100B) used in an xEV.

The smart lead-acid battery system 100A or 100B can provides real-time communication that includes one or more of the following: identifies potential issues before they happen, provides emergency power that may be critical for EV and autonomous vehicles, allows proactive replacement before failure, and optimizes performance of the low-voltage power supply.

Various forces are shaping the automotive battery market. Consumer demand, policy and regulations, and advanced vehicles are example force changing the landscape for automotive batteries. Consumers are seeking additional comfort, connectivity, infotainment, reliability, and safety features in their vehicles. As a result, vehicle electrical loads are increasing significantly. Original equipment manufacturers (OEMs) continue to focus on improvising fuel efficiency and reducing emissions. As a result, OEM's need to fulfill increasingly stringent regulatory requirements. Governments and regulatory bodies have an increased emphasis on ESG practices. Lastly, the increasing electrification of the car parc and the rise of ADAS/ autonomous technology features in vehicles provide a tailwind to the adoption of advanced battery technologies. Accordingly, improved battery technology is continuously being developed.

FIG. 20 discloses possible scenarios and outcomes on how the smart lead-acid battery system 100A or 100B, above, can address the scenario. The lead-acid battery system 100A or 100B solution can support multiple autonomy levels and provide an alternative to lithium-ion solutions. The lead-acid battery system 100A or 100B includes "smart" sensor technology to predict the battery's state of health, which encourages and promotes a proactive replacement. The lead-acid battery system 100A or 100B can understand the battery's status. This can enable OEMs to optimize performance of the vehicle (e.g., fuel consumption, emissions, performs) and improves the consumer's experience. Further, the lead-acid system 100A and 100B can understand the battery's status, such as battery aging and when battery should be charged for how long).

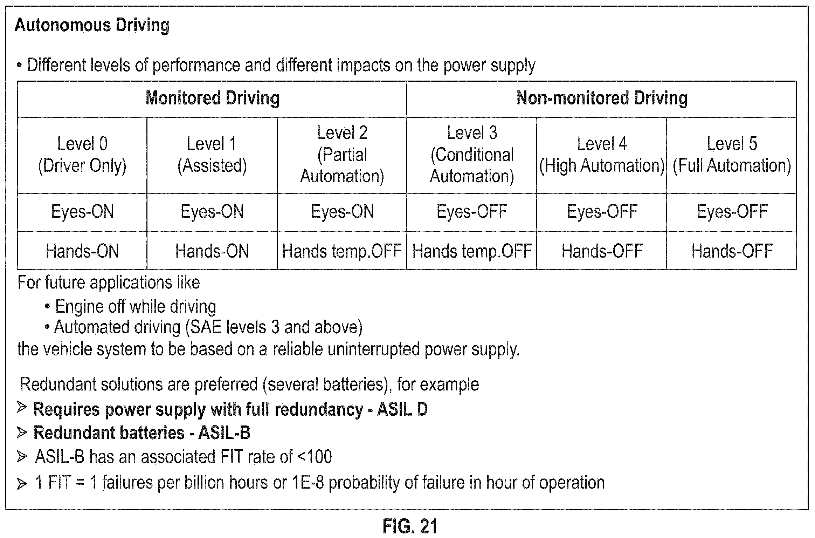

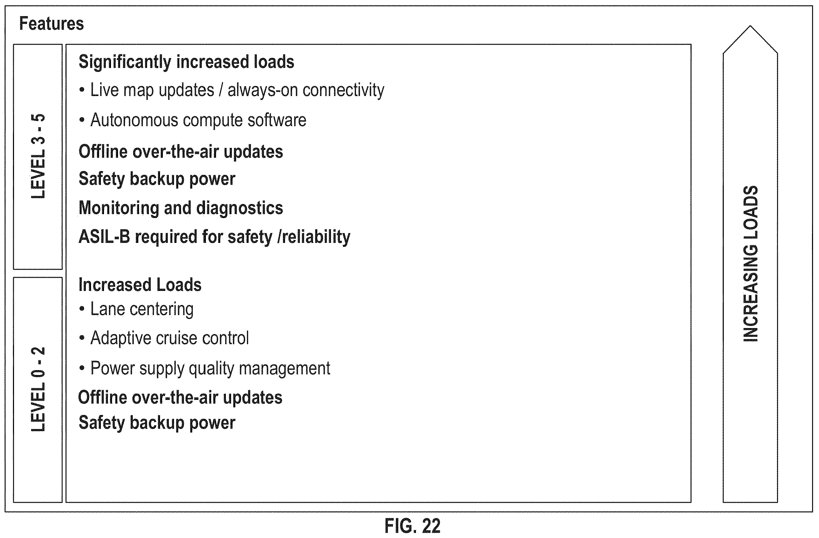

The Society of Automotive Engineers (SAE) defines six levels of driving automation ranging from zero (fully manual) to five (fully autonomous). See FIG. 21. These levels have been adopted by the U.S. Department of Transportation as an example. FIG. 22 provides some example features for the various levels. The levels are described as followed.

Level 0 is referred to as no driving automation: manually controlled. The human driver provides the "dynamic driving task" although there may be systems in place to help the driver.

Level 1 is referred to as driver assistance. This is the lowest level of automation. The vehicle features a single automated system for driver assistance, such as steering or accelerating (cruise control).

Level 2 is referred to as partial driving automation. This means advanced driver assistance systems (ADAS) are included. The vehicle can control both steering and accelerating/decelerating; however, the automation falls short of self-driving because a human sits in the driver's seat and can take control of the car at any time.

Level 3 is referred to as conditional driving automation. The jump from level 2 to level 3 is substantial from a technological perspective, but subtle if not negligible from a human perspective. Level 3 vehicles have "environmental detection" capabilities and can make informed decisions for themselves, such as accelerating past a slow-moving vehicle. However, level 3 still requires human override. The driver must remain alert and ready to take control if the system is unable to execute the task.

Level 4 is referred to as high driving automation. The key difference between level 3 and level 4 automation is that level 4 vehicles can intervene if things go wrong or there is a system failure. In this sense, these cars do not require human interaction in most circumstances. However, a human still has the option to manually override. Level 4 vehicles can operate in self-driving mode.

Level 5 is referred to as full driving automation. Level 5 vehicles do not require human attention. Level 5 cars may not even have steering wheels or acceleration/brake pedals.

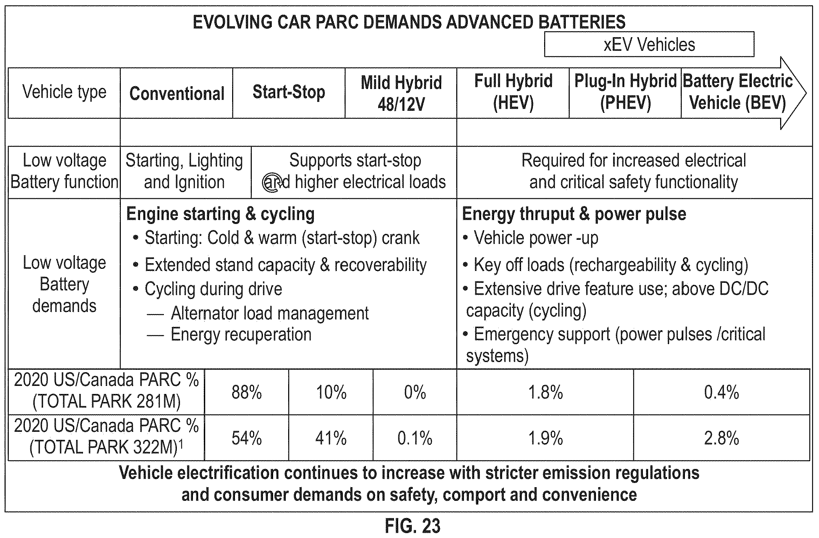

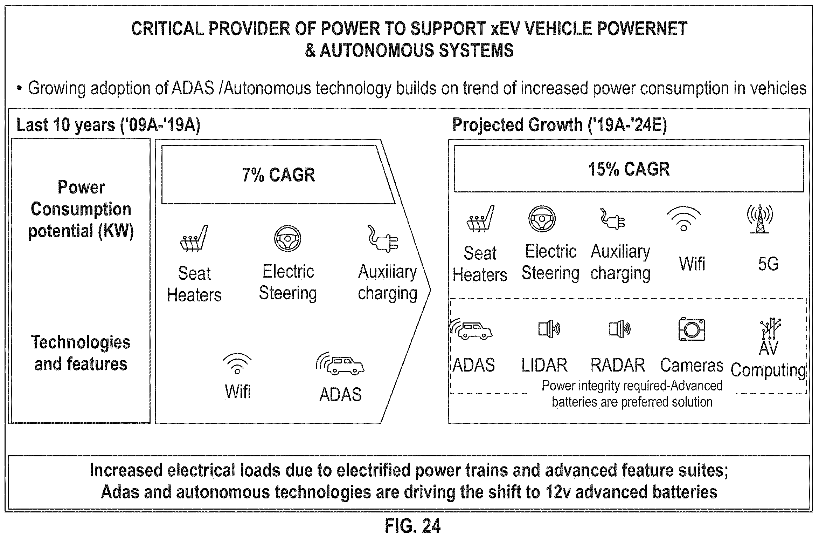

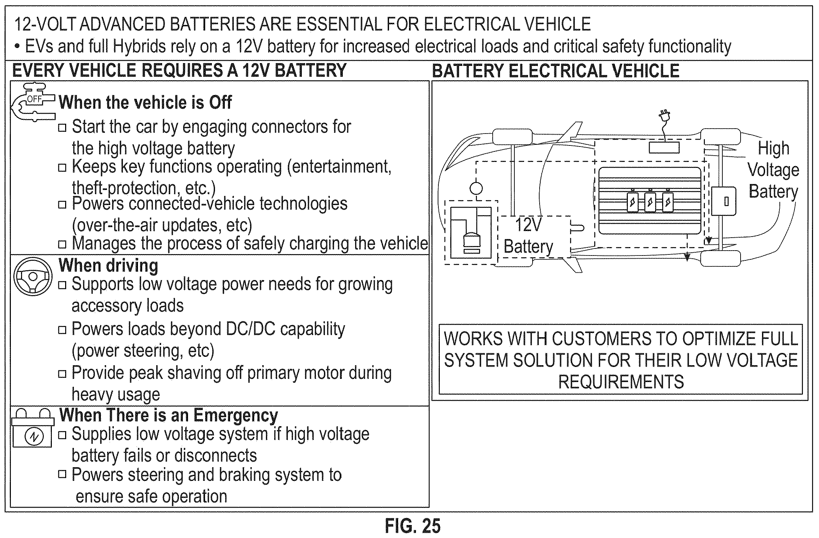

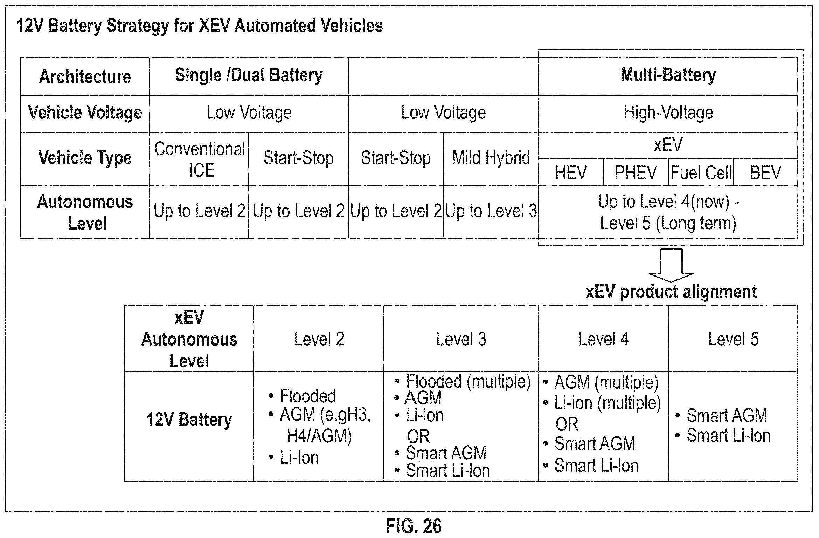

FIG. 23 shows example vehicles from vehicles with ICE only to vehicles being electric only and showing example energy demands for each type of vehicle (see also FIGs. 24 and 25 for further example energy demands). Similar to the amount of automation directed towards driving as the SAE levels increase in the SAE standard, the amount of battery intelligence and reliability for the battery should increase as the automation level increases. This is shown in FIG. 26, which discloses battery strategies for xEV automated vehicles.

With reference to FIG. 26, as the level of vehicle automation increases, the level of performance and the level of impact on the power supply (e.g., battery) also increases. For example, at level 0, the driver provides full control of the vehicle, and zero or essentially zero automation is required of the vehicle. This results in a low level of performance requirement on the battery and a zero-intelligence requirement on the vehicle. The only true requirement for the battery is to provide sufficient cranking current to start the ICE. No battery intelligence is required since an external key may make/break the circuit connect external to the battery. Accordingly, all of 1) functional safety, 2) diagnostic/algorithm requirements, 3) monitoring and integration, 4) electronics and software, and 5) value proposition is either low or nonexistent.

On the other end of the automation spectrum, at level 5, the driver provides zero control of the vehicle, and full automation of the vehicle is required by or from the vehicle. This results in a very high level of performance requirement on the battery and a very high intelligence requirement on the vehicle. If the vehicle is not being powered properly and is moving, this is a potentially dangerous situation for the vehicle and surroundings. High battery intelligence is required since it needs to confirm reliability and power is available to the electronics of the vehicle.

Accordingly, for applications like a) engine off while driving and/or b) automated driving (SAE levels 3 and above) then the vehicle is to be based on a reliable, uninterrupted power supply. For these application s, redundant solutions are preferred, including several batteries or battery systems. Additional solutions can include, for example, a power supply with full redundancy meeting Automotive Safety Integrity Level (ASIL) D, redundant batteries meeting ASIL-B, a failure in time (FIT) rate of less than 100, and 1 failure per billion hours of operation. Automotive Safety Integrity Level (ASIL) is a risk classification scheme defined by the ISO 26262 - Functional Safety for Road Vehicles standard.

The intelligent lead-acid battery system 100A or 100B can include levels of 1) functional safety requirements, 2) diagnostic/algorithms, 3) cell-level monitoring and integration, 4) electronics and software, and 5) value proposition. The levels can vary depending on the levels of vehicle automation. One example goal of the lead-acid battery system 100A or 100B to enable battery State of Function (SOF) prediction for xEV and Autonomous applications. Another example goal of the lead-acid battery system 100A or 100B is enabling predictive battery replacement (State of Health - SOH).

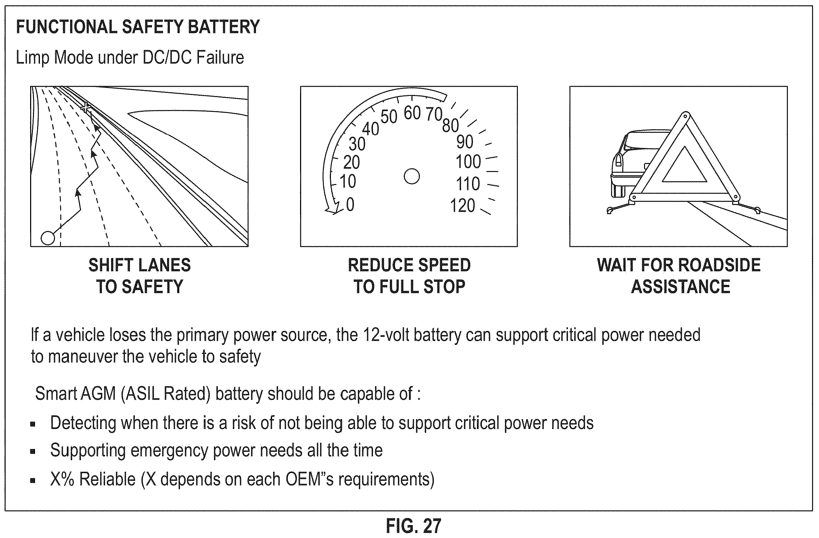

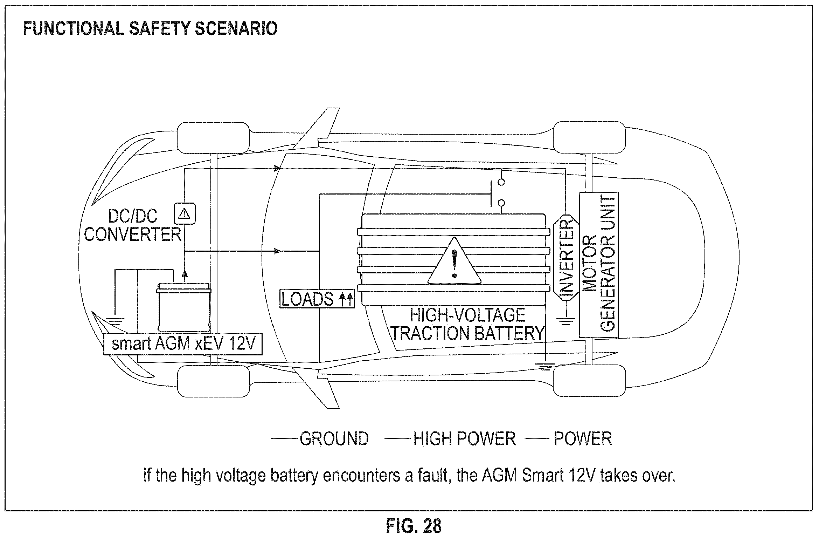

FIG. 27 is an example of the importance of battery functionality. If a vehicle loses the primary power source, the 12-volt battery should support critical power needed to maneuver the vehicle to safety. The lead-acid battery system 100A or 100B can 1) detect when there is risk of not being able to support critical power needs, 2) be able to support emergency power needs all of the time, and 3) be X percent reliable, where X depends on the vehicle OEM's requirements. In the case of a lost primary power source, the vehicle with the help of the safety integrity battery should be able to a) shift lanes to safety, b) controllably reduce speed to full stop, c) call for roadside assistance, and d) provide emergency power (e.g., for heat) while the vehicle waits for help. As show in FIG. 28, if the high-voltage battery encounters a fault which causes DC/DC power not able to provide 12V power, or in case of DC/DC power failure, the lead acid battery system 100A or 100B can take over.

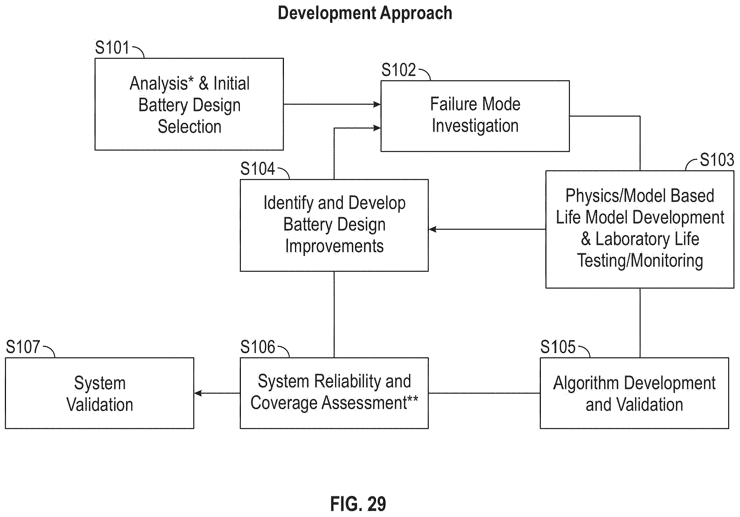

FIG. 29 discloses a methodology for developing the lead-acid battery system 100A or 100B as a safety integrity battery. At step S101, a requirements analysis is performed. The analysis includes learning from the vehicle OEM the specifications for multi-battery applications. Also at step S101, an initial battery design is selected

At step S102, a failure mode investigation is performed on selected initial battery design. At step S103, a physics-based life model is developed. Also, development and laboratory life test and monitoring are performed.

Based on the steps of S102 and S103, improvements for the battery design can occur at step S104. This can include identifying and developing improvements for the battery design. The improved battery can then perform steps 102 and 103. Alternatively, based on steps S102 and S103, algorithm development and validation can occur at step S105. This includes using the battery design resulting from step S103 to develop the algorithm use for the battery design.

At step S106, system reliability and coverage assessment can occur using the developed battery design and related algorithm. Test methods, executable in vehicle firmware, can be derived through collaboration with the OEM. Depending on the result, the process can return to step 104 or proceed with system validation, step S107.

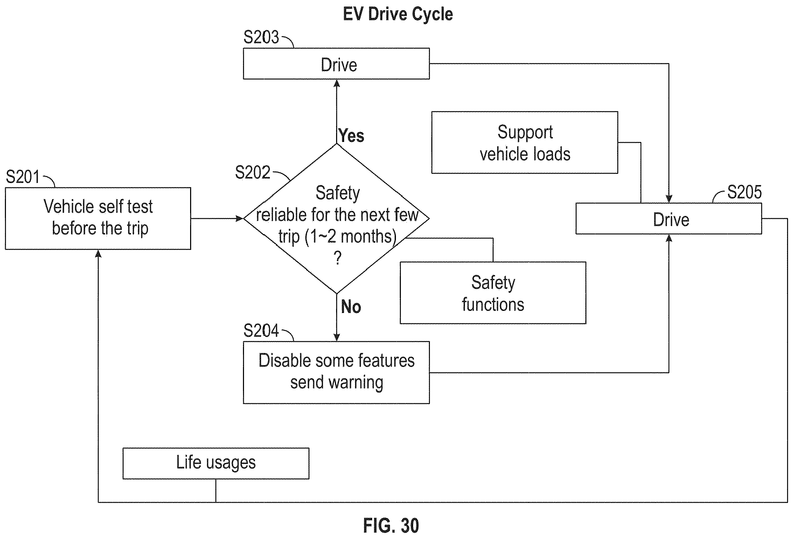

FIG. 30 provides a process for an EV drive cycle. At step S201, the vehicle performs a "self-test" before the trip. The test determines whether any potential vehicle errors may limit the trip or reduce the quality of the trip. Included with the self-test is a test of the vehicle batter(ies). The test may determine the reliability (or safety reliability) for the vehicle/battery. This can include the potential reliability for the next trip and/or for the next defined number of trips, step S202. If the reliability, for example, is within a threshold, then the vehicle can proceed to a drivable state, step S203. Alternatively, the vehicle can disable one or more features, prevent operation, and/or send warnings (e.g., to the driver, to the vehicle owner), step S204. Alternative reliability factors can be used in alternative to reliability. At the end of the trip, step S205, the vehicle can charge for the next trip at step. While changing and before the next trip, the process can be re-initiated at step S201. During the EV drive cycle, the smart battery system can monitor safety function of the battery, support vehicle loads, and monitor life use. The level, tolerance, and reliability of each failure monitoring (e.g., safety function, level of support for vehicle loads, and remaining battery life) varies based on the different levels of automation described earlier.

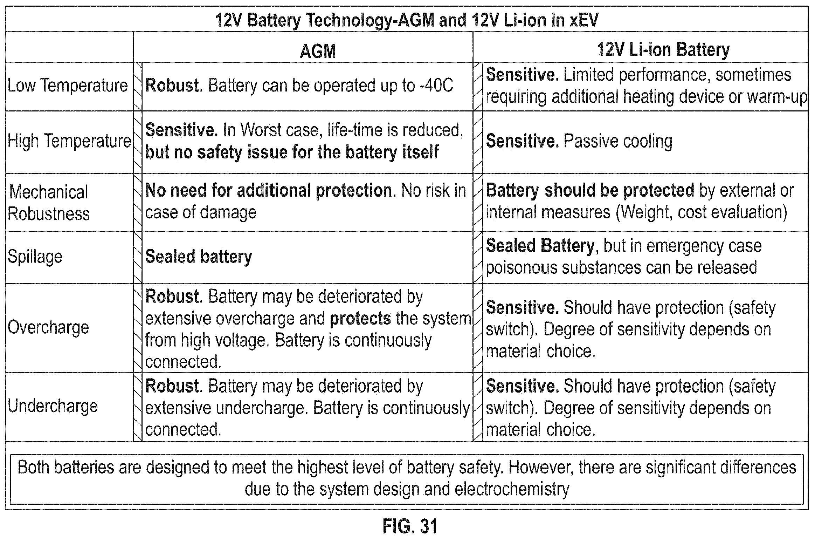

FIGs. 31-33 provide tables comparing value propositions between AGM and 12V Li-ion in xEVs. As shown in FIGs. 31-33, many value propositions are in favor of the intelligent lead-acid battery system 100A or 100B.

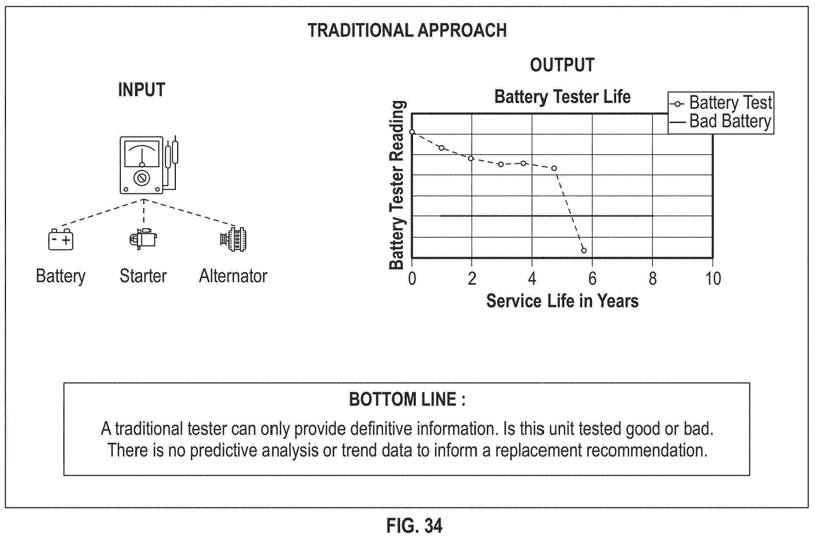

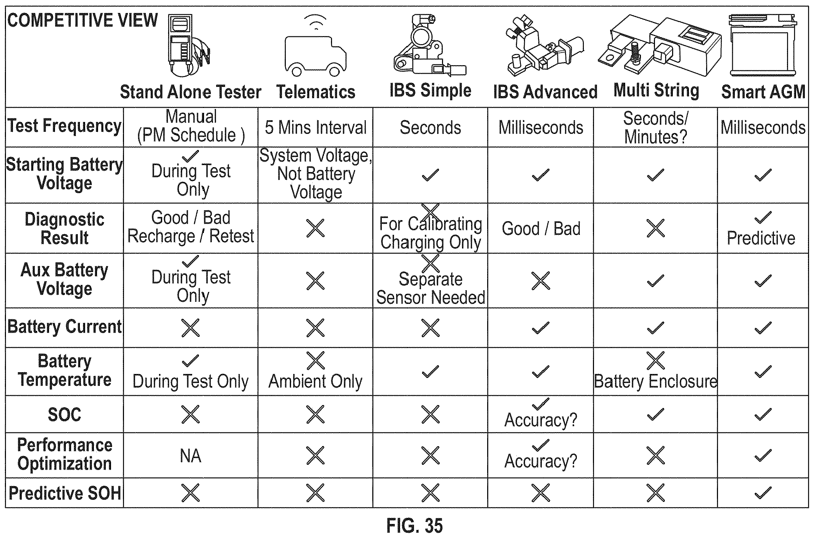

FIG. 34 shows a traditional approach for monitoring a traditional lead-acid battery. A traditional tester can attach to the leads of the battery, starter, and/or alternator. The traditional tester can only provide definitive information: the battery is good or bad. The traditional tester does not provide predictive analysis or trend data to inform a replacement battery. The consumer typically does not realize a battery is bad until the vehicle does not start or the battery powers the accessories coupled to it. FIG. 35 shows alternative means for testing a lead-acid battery, including with the smart lead-acid battery system 100A or 100B. Many points of comparison are shown in FIG. 35 including test frequency, starting battery voltage, diagnostic result, auxiliary battery voltage, battery current, battery temperature, state of charge (SOC), performance optimization, predictive state of health (SOH). The prior test systems can be referred to as intelligent battery sensors, whereas the lead-acid battery system 100A or 100B has an internal battery sensor.

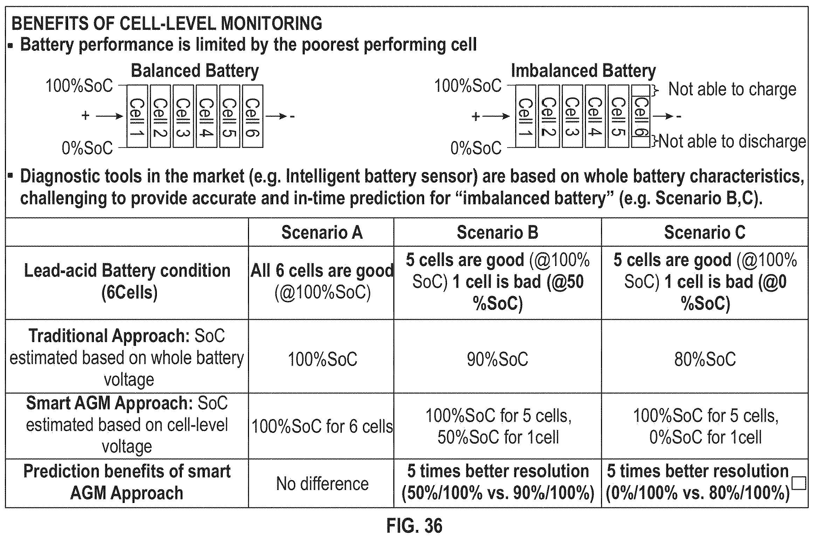

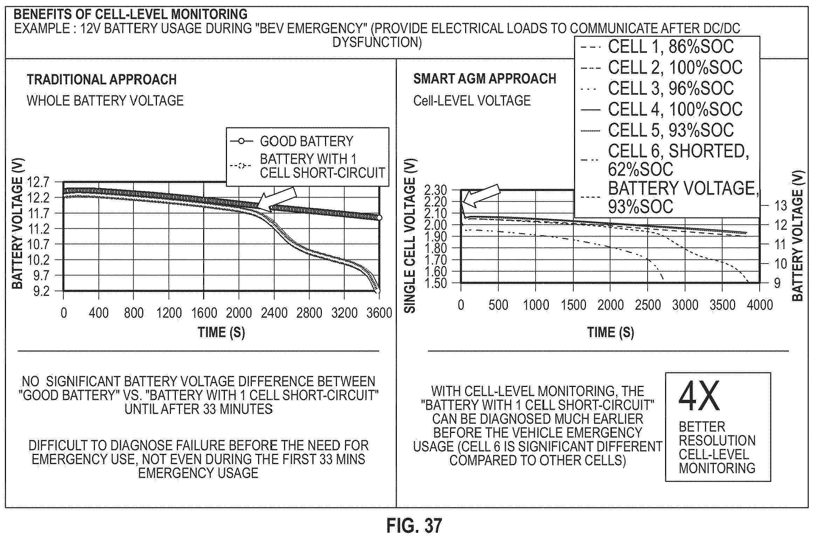

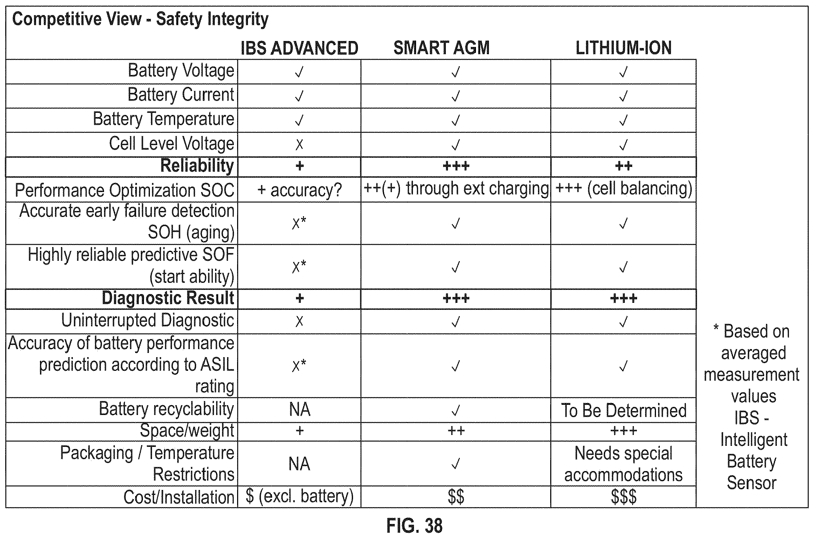

FIG. 36 discloses various benefits of cell-level monitoring in a battery, whether being a group of cells or singular cells. Typically, for a lead-acid battery, the battery performance is limited by the poorest performing cell. A cell may be or become imbalanced due to manufacturing variances, manufacturing issues, damage, etc. Diagnostic tools in the market (see FIG. 35) are based on whole battery characteristics, which are challenging to provide accurate and in-time prediction for the imbalanced battery. See scenarios A versus B versus C in FIG. 36. However, the smart lead-acid battery system 100A or 100B provide significantly better resolution and prediction benefits than traditional lead-acid batteries. Further benefits of cell-level monitoring are shown in FIG. 37, and further benefits of a smart lead-acid battery are shown in FIG. 38. With reference to these figures, monitoring for individual battery cell voltages can identify an imbalanced or faulty battery sooner (e.g., cell 6 in the figures) than solely monitoring the battery voltage (best shown in FIG. 37). In alternative to monitoring cell voltages, the smart lead-acid battery system 100A or 100B can monitor one or more individual cell temperatures (two cell temperature sensors 310B are shown in FIG. 9) to identify an imbalanced or potential thermal runaway situation sooner. This greatly increases the resolution of the lead-acid battery system 100A or 100B.

It is also envisioned that different techniques can be used to identify different scenarios for the of the lead-acid battery system 100A or 100B. For example, one scenario can include monitoring the battery cells for the minimum cell voltage (or temperature) as shown in FIGs. 36 and 37. Another scenario can include averaging multiple battery cell voltages (or temperatures) for probability predictions. Another scenario can include monitoring a running average of a battery cell voltage (or temperature) or a plurality of battery cell voltages (or temperatures). Yet another variation includes comparing one or more cell voltages (or temperatures) to the battery voltage (or compartment voltage or environment voltage) for making observations. An even yet another variation includes looking at multiple parameters concurrently to make a decision. Other variations are envisioned.

For the traditional approach, it is difficult to diagnose failure before the need for emergency use. Alternatively, with cell-level monitoring, the battery with a cell failing can be diagnosed much earlier (see FIG. 37). Earlier diagnosis allows for the battery system 100A, 100B and/or the apparatus (e.g., vehicle) to modify its/their operation to prolong use of the battery system 100A, 100B. For example, the vehicle can shift loads or operation from the damaged battery system 100A, 100B to extend usage time of the battery system 100A, 100B. As another example, the vehicle can attempt overcharging the battery system 100A, 100B (typically referred to as an "equalization charge") and more specifically the damaged cell, to prolong possible use of the battery system. Extending use can mean the difference between immediate loss of power and extending power life to allow the vehicle to get to a service location, for example.

Accordingly, the invention provides a new and useful intelligent lead-acid battery system and method of operating the same.

Some of the systems, components, and/or processes described above can be realized in hardware or a combination of hardware and software and can be realized in a centralized fashion in one processing system or in a distributed fashion where different elements are spread across several interconnected processing systems. Any kind of processing system or another apparatus adapted for carrying out the methods described herein is suited. A typical combination of hardware and software can be a processing system with computer-usable program code that, when being loaded and executed, controls the processing system such that it carries out the methods described herein. Some of the systems, components and/or processes also can be embedded in a computer-readable storage, such as a computer program product or other data programs storage device, readable by a machine, tangibly embodying a program of instructions executable by the machine to perform methods and processes described herein. These elements also can be embedded in an application product which comprises all the maintenance conditions enabling the implementation of the methods described herein and which, when loaded in a processing system, is able to carry out these methods.

Furthermore, some arrangements described herein may take the form of a computer program product embodied in one or more computer-readable media having computer-readable program code embodied, e.g., stored, thereon. Any combination of one or more computer-readable media may be utilized. The computer-readable medium may be a computer-readable signal medium or a computer-readable storage medium. The phrase "computer-readable storage medium" means a non-transitory storage medium. A computer-readable storage medium may be, for example, but not limited to, an electronic, magnetic, optical, electromagnetic, infrared, or semiconductor system, apparatus, or device, or a suitable combination of the foregoing. More specific examples (a non-exhaustive list) of the computer-readable storage medium would include the following: a portable computer diskette, a hard disk drive (HDD), a solid-state drive (SSD), a read-only memory (ROM), an erasable programmable read-only memory (EPROM or Flash memory), a portable compact disc read-only memory (CD-ROM), a digital versatile disc (DVD), an optical storage device, a magnetic storage device, or any suitable combination of the foregoing. In the context of this document, a computer-readable storage medium may be any tangible medium that can contain or store a program for use by or in connection with an instruction execution system, apparatus, or device.

Program code embodied on a computer-readable medium may be transmitted using an appropriate medium, including but not limited to wireless, wireline, optical fiber, cable, RF, etc., or any suitable combination of the foregoing. Computer program code for carrying out operations for aspects of the present arrangements may be written in any combination of one or more programming languages. Instructions of the program code may be executed entirely at one location, or processor, or across multiple locations, or processors, as discussed herein.

The terms "a" and "an," as used herein, are defined as one or more than one. The term "plurality," as used herein, is defined as two or more than two. The term "another," as used herein, is defined as at least a second or more. The terms "including" and/or "having," as used herein, are defined as comprising (i.e., open language). The phrase "at least one of ... and ...." as used herein refers to and encompasses any and all possible combinations of one or more of the associated listed items. As an example, the phrase "at least one of A, B, and C" includes A only, B only, C only, or any combination thereof (e.g., AB, AC, BC, or ABC).

The term "traverse a threshold" means to ascend, descend, or cross a threshold or threshold value. That is, a value can change from above a threshold to below a threshold or change from below a threshold to above a threshold to traverse a threshold. One skilled in the art will also understand if a first value is already on the improper or nonpreferred side of a threshold then that first value has traversed the threshold.

It should also be noted that, in some alternative implementations, the functions noted in the block may occur out of the order noted in the figures. For example, two blocks shown in succession may, in fact, be executed substantially concurrently, or the blocks may sometimes be executed in the reverse order, depending upon the functionality involved.

For the purpose of this disclosure, the term "coupled" means the joining of two members directly or indirectly to one another. Such joining may be stationary in nature or moveable in nature. Such joining may be achieved with the two members, or the two members and any additional intermediate members being integrally formed as a single unitary body with one another or with the two members or the two members and any additional intermediate members being attached to one another. Such joining may be permanent in nature or may be removable or releasable in nature.

The terms fixedly, non-fixedly, and removably, and variations thereof, may be used herein. The term fix, and variations thereof, refer to making firm, stable, or stationary. It should be understood, though, that fixed does not necessarily mean permanent - rather, only that a significant or abnormal amount of work needs to be used to make unfixed. The term removably, and variations thereof, refer to readily changing the location, position, station. Removably is meant to be the antonym of fixedly herein. Alternatively, the term non-fixedly can be used to be the antonym of fixedly.

Preferences and options for a given aspect, feature or parameter of the disclosure should, unless the context indicates otherwise, be regarded as having been disclosed in combination with any and all preferences and options for all other aspects, features, and parameters of the disclosure.

In the following, some aspects of the present disclosure are summarized:
Aspect 1: A method of monitoring a lead-acid battery system comprising a lead-acid battery having a plurality of cells, the method comprising:
   sensing a first parameter associated with a first one or more cells of the plurality of cells;
   sensing a second parameter associated with a second one or more cells of the plurality of cells, the second one or more cells being different from the first one or more cells; and
   determining a state of the lead-acid battery based on the first parameter and the second parameter.
Aspect 2: The method of Aspect 1, wherein the first parameter is a first cell voltage and the second parameter is a second cell voltage.
Aspect 3: The method of Aspect 2, wherein the state is a health of the lead-acid battery and wherein the determining the state includes determining a health of the lead-acid battery based on the first voltage and the second voltage.
Aspect 4: The method of Aspect 2, wherein the state is a function of the lead-acid battery and wherein the determining the function includes determining the function of the lead-acid battery based on the first voltage and the second voltage.
Aspect 5: The method of Aspect 2, wherein the state is a charge of the lead-acid battery and wherein the determining the charge includes determining a function of the lead-acid battery based on the first voltage and the second voltage.
Aspect 6: The method of one of Aspects 2-5, and further comprising:
   - determining a voltage value based on the first cell voltage;
   - monitoring whether the voltage value traverses a threshold value; and
   - identifying a first state for the lead-acid battery when the voltage value traverses the threshold value.
Aspect 7: The method of Aspect 6, wherein the threshold value indicates a first cell voltage is low, and the first state is a potential fault with the first cell.
Aspect 8: The method of Aspect 6, wherein the threshold value indicates a first cell voltage is low, and the first state is a potential fault with the lead-acid battery.
Aspect 9: The method of one of Aspects 2-8, and further comprising:
   - sensing a third voltage of the lead-acid battery, the third voltage being a battery voltage of the lead-acid battery; and
   - wherein the determining the state of the lead-acid battery is further based on the third voltage.
Aspect 10: The method of Aspect 1, wherein the sensing the first parameter includes sensing a first voltage of a first number of cells of the plurality of cells, the first number being greater than one and less than the plurality of cells, wherein the sensing the second parameter includes sensing a second voltage of a second number of cells of the plurality of cells, the second number being greater than one and less than the plurality of cells, and wherein the determining the state of the lead-acid battery includes determining the state of the lead-acid battery based on the first voltage and the second voltage.
Aspect 11: The method of Aspect 10, wherein a number of the plurality of cells is six, and wherein the first number of cells are three of the six cells, and the second number of cells are three different cells of the six cells.
Aspect 12: The method of Aspect 2, wherein the lead-acid battery is defined by (n) cells, wherein the sensing steps further comprises sensing (n) cell voltages associated with the (n) cells, each cell voltage of the (n) cell voltages being associated with a respective cell, and wherein determining the state of the lead-acid battery is further based on the (n) cell voltages.
Aspect 13: The method of Aspect 12, and further comprising:
   - determining (n) voltage values based on the sensed (n) cell voltages, each cell voltage value of the (n) cell voltages being associated with a respective sensed cell voltage of the sensed (n) cell values;
   - monitoring whether one or more of the (n) voltage values traverse a threshold value indicative of whether one or more cell voltages are low; and
   - identifying a first state for the lead-acid battery when one or more of the (n) voltage values traverse the threshold value.
Aspect 14: The method of Aspect 1, wherein the first parameter is a first cell temperature and the second parameter is second cell temperature.
Aspect 15: The method of Aspect 14, and further comprising:
   - determining a temperature value based on the sensed first cell temperature;
   - monitoring whether the temperature value traverses a threshold value; and
   - identifying a first state for the lead-acid battery when the temperature value traverses the threshold value.
Aspect 16: The method of Aspect 15, wherein the threshold value indicates the first cell temperature is high, and the first state is a potential fault with the first cell.
Aspect 17: The method of Aspect 16, wherein the threshold value indicates a first cell temperature is high, and the first state is a potential fault with the lead-acid battery.
Aspect 18: The method of one of Aspects 14-17, and further comprising:
   - sensing a third temperature associated with the lead-acid battery, the third temperature being an ambient or environment temperature for the lead-acid battery; and wherein the determining the state of the lead-acid battery is further based on the third temperature.
Aspect 19: The method of Aspect 1, wherein the sensing the first parameter includes sensing a first temperature of a first number of cells of the plurality of cells,
   wherein the sensing the second parameter includes sensing a second temperature of a second number of cells of the plurality of cells, and wherein the determining the state of the lead-acid battery includes determining the state of the lead-acid battery based on the first temperature and the second temperature.
Aspect 20: The method of Aspect 1, and further comprising:
   - determining a level of automation for a vehicle for the lead-acid battery system to be placed in;
   - determining a threshold value indicative of a fault based on the level of automation;
   - determining a first parameter value using the sensed first parameter;
   - monitoring whether the first parameter value traverses the threshold value; and
   - identifying the state of the lead-acid battery when the first parameter value traverses the threshold value.
Aspect 21: The method of Aspect 20, wherein determining a level of automation includes receiving the level of automation.
Aspect 22: The method of one of Aspects 20 or 21, wherein the fault relates to a functional safety condition of the lead-acid battery system, the vehicle, or both the lead-acid battery and the vehicle.
Aspect 23: The method of one of Aspects 20 or 21, wherein the fault relates to a potential usage fault of the lead-acid battery system, the vehicle, or both the lead-acid battery system and the vehicle.
Aspect 24: The method of one of Aspects 20 or 21, wherein the fault relates to a potential load fault of the lead-acid battery system, the vehicle, or both the lead-acid battery system and the vehicle.
Aspect 25: The method of one of Aspects 20-24, wherein the level of automation is based on SAE International automation levels.
Aspect 26: The method of one of Aspects 1-25, the method comprising:
   - modifying operation of the lead-acid battery system based on the state.
Aspect 27: A lead-acid battery system comprising:
   - a lead-acid battery comprising a plurality of cells;
   - a first parameter sensor associated with a first one or more cells of the plurality of cells;
   - a second parameter sensor associate with a second one or more cells of the plurality of cells; and
   - a battery monitoring unit coupled to the first parameter sensor, the second parameter sensor, and the lead-acid battery, the battery monitoring unit to perform one of the methods of Aspects 1-26.
Aspect 28: The lead-acid battery system of Aspect 27, wherein the lead-acid battery further comprises an acid solution, wherein the first cell of the plurality of cells has a cathode, an anode, and a separator, and wherein at least one of the cathodes and the anode comprises lead.
Aspect 29: The lead-acid battery system of one of Aspects 27 or 28, and further comprising:
   - a cells compartment;
   - a battery monitoring system compartment;
   - a wall positioned between the cells compartment and the battery monitoring system compartment;
   - a first post extending through the wall between the cells compartment and the battery monitoring system compartment, the first post associated with the first one or more cells of the plurality of cells, the first parameter sensor coupled to the first post; and
   - a second post extending through the wall between the cells compartment and the battery monitoring system compartment, the second post associated with the second one or more cells of the plurality of cells, the second parameter sensor coupled to the second post.
Aspect 30: The lead-acid battery system of Aspect 29, further comprising a seal around the first post.
Aspect 31: The lead-acid battery system of Aspect 30, wherein the seal includes an O-ring.
Aspect 32: The lead-acid battery system of one of Aspects 30 or 31, wherein the seal includes an epoxy.
Aspect 33: The lead-acid battery system of Aspect 29, further comprising a terminal extending through the wall between the cells compartment and the battery monitoring system compartment, wherein the terminal includes lead.
Aspect 34: The lead-acid battery system of one of Aspects 27 or 28, wherein the first parameter sensor is a first cell voltage sensor and the second parameter sensor is a second cell voltage sensor, wherein the first parameter is a first cell voltage and the second parameter is a second cell voltage, and wherein the lead-acid battery system further comprises:
   - a housing defining at least in part a cells compartment and at least in part a battery monitoring system (BMS) compartment, and including a wall disposed between the cells compartment and the BMS compartment;
   - the plurality of battery cells housed in the cells compartment and including a first battery cell and a second battery cell, the first battery cell having a first post and a second post associated with the first battery cell, the first post and the second post protruding through the wall between the cells compartment to the BMS compartment; and
   - a battery monitor system (BMS) housed by the BMS compartment, the BMS including the first voltage sensor electrically coupled to the first post and the second post.
Aspect 35: The lead-acid battery system of Aspect 34, wherein the second battery cell has a third post and a fourth post associated with the second battery cell, the third post and the fourth post protruding through the wall between the cells compartment to the BMS compartment, and wherein the BMS further includes a second voltage sensor electrically coupled to the third post and the fourth post.
Aspect 36: The lead-acid battery system of Aspect 35, wherein the plurality of battery cells housed in the cells compartment further comprises a third battery cell, the third battery cell having the second post and the third post associated with the third battery cell, the second post and the third post protruding through the wall between the cells compartment to the BMS compartment, and wherein the BMS further includes a third voltage sensor electrically coupled to the second post and the third post.
Aspect 37: The lead-acid battery system of Aspect 36, further comprising:
   - a first terminal strap electrically coupling the first battery cell to the second battery cell;
   - a second terminal strap electrically coupling the second battery cell to the third battery cell; and wherein the first terminal strap includes the second post, and the second terminal strap includes the third post.
Aspect 38: The lead-acid battery system of one of Aspects 34-37, wherein the housing further includes a cell base, a cell cover, a BMS base, and a BMS cover, and wherein the cell cover and the BMS base includes the wall between the cells compartment the BMS compartment.
Aspect 39: The lead-acid battery system of one of Aspects 34-38, wherein the BMS further includes one or more of a battery voltage sensor to sense a battery voltage, a battery current sensor to sense a battery current, and a temperature sensor to sense a temperature.
Aspect 40: The lead-acid battery system of one of Aspects 27-39, wherein the lead-acid battery system further comprises a display coupled to the housing, and wherein the lead-acid battery system outputs the state of the lead-acid battery via the display.
Aspect 41: The lead-acid battery system of Aspect 40, wherein the display includes a plurality of light-emitting diodes.
Aspect 42: The lead-acid battery system of one of Aspects 40 or 41, wherein the lead-acid battery further comprises a wired communication port disposed in the housing, and wherein the lead-acid battery system outputs the state of the lead-acid battery via the wired communication port.
Aspect 43: The lead-acid battery system of one of Aspects 40-42, wherein the lead-acid battery further comprises a radio frequency transmitter supported by the housing, and wherein the lead-acid battery system outputs the state of the lead-acid battery via the radio frequency transmitter.
Aspect 44: The lead-acid battery system of Aspect 27, wherein the battery monitoring unit comprises a processor and memory disposed and in communication with the first parameter sensor and the second parameter sensor, the memory including instructions executable by the processor to cause the battery system to perform the method of Aspects 1-26.
Aspect 45: A method of monitoring a lead-acid battery system comprising a lead-acid battery having a plurality of cells, the method comprising:
   - sensing a first voltage of a first number of cells of the plurality of cells, the first number being greater than one and less than the plurality of cells;
   - sensing a second voltage of a second number of cells of the plurality of cells, the second number being greater than one and less than the plurality of cells; and
   - determining a state of the lead-acid battery based on the first voltage and the second voltage.
Aspect 46: The method of Aspect 45, wherein the plurality of cells is six total cells, and wherein the first one or more cells are three of the six cells, and the second one or more cells are three different cells of the six cells.
Aspect 47: The method of one of Aspects 45 or 46, wherein the state is a health of the lead-acid battery and wherein the determining the state includes determining a health of the lead-acid battery based on the first voltage and the second voltage.
Aspect 48: The method of one of Aspects 45 or 46, wherein the state is a function of the lead-acid battery and wherein the determining the function includes determining the function of the lead-acid battery based on the first voltage and the second voltage.
Aspect 49: The method of one of Aspects 46 or 46, wherein the state is a charge of the lead-acid battery and wherein the determining the charge includes determining a function of the lead-acid battery based on the first voltage and the second voltage.
Aspect 50: The method of one of Aspects 45-49, and further comprising:
   - determining a voltage value based on the first voltage;
   - monitoring whether the voltage value traverses a threshold value; and
   - identifying a first state for the lead-acid battery when the voltage value traverses the threshold value.
Aspect 51: The method of Aspect 50, wherein the first state is a potential fault with the lead-acid battery.
Aspect 52: The method of one of Aspects 45-51, and further comprising:
   - sensing a third voltage of the lead-acid battery, the third voltage being a battery voltage of the lead-acid battery; and
   - wherein the determining the state of the lead-acid battery is further based on the third voltage.
Aspect 53: A lead-acid battery system comprising:
   - a lead-acid battery comprising a plurality of cells;
   - a first voltage sensor to sense a first voltage;
   - a second voltage sensor to sense a second voltage; and
   - a battery monitoring unit coupled to the first voltage sensor, the second voltage sensor, and the lead-acid battery, the battery monitoring unit to perform one of the methods of Aspects 21-28.
Aspect 54: A vehicle comprising the lead-acid battery system of Aspect 53.
Aspect 55: A method of monitoring a lead-acid battery system having a lead-acid battery with (n) battery cells, the method comprising:
   - sensing (n) cell voltages associated with the (n) cells, each cell voltage of the (n) cell voltages being associated with a respective cell; and
   - determining a state of the lead-acid battery based on the (n) cell voltages.
Aspect 56: The method of Aspect 55, and further comprising:
   - determining (n) voltage values based on the sensed (n) cell voltages, each cell voltage value of the (n) cell voltages being associated with a respective sensed cell voltage of the sensed (n) cell values;
   - monitoring whether one or more of the (n) voltage values traverse a threshold value indicative of whether one or more cell voltages are low; and
   - identifying a first state for the lead-acid battery when one or more of the (n) voltage values traverse the threshold value.
Aspect 57: The method of one of Aspects 55 or 56, wherein the state is a health of the lead-acid battery and wherein the determining the state includes determining a health of the lead-acid battery based on the (n) voltage values.
Aspect 58: The method of one of Aspects 55 or 56, wherein the state is a function of the lead-acid battery and wherein the determining the function includes determining the function of the lead-acid battery based on the (n) voltage values.
Aspect 59: The method of one of Aspects 55 or 56, wherein the state is a charge of the lead-acid battery and wherein the determining the charge includes determining a function of the lead-acid battery based on the (n) voltage values.
Aspect 60: The method of one of Aspects 55-59, wherein the first state is a potential fault with the lead-acid battery.
Aspect 61: A lead-acid battery system comprising:
   - a lead-acid battery comprising (n) cells;
   - one or more voltage sensors to sense (n) cell voltages; and
   - a battery monitoring unit coupled to the one or more voltage sensors and the lead-acid battery, the battery monitoring unit to perform one of the methods of Aspects 55-60.
Aspect 62: A vehicle comprising the lead-acid battery system of Aspect 61.
Aspect 63: A lead-acid battery system comprising:
   - a cells compartment;
   - a battery monitoring system compartment;
   - a wall positioned between the cells compartment and the battery monitoring system compartment;
   - a post extending through the wall between the cells compartment and the battery monitoring system compartment; and
   - a sensor coupled to the post.
Aspect 64: The battery system of Aspect 63, further comprising a seal around the post.
Aspect 65: The battery system of Aspect 64, wherein the seal includes an O-ring.
Aspect 66: The battery system of one of Aspects 64 or 65, wherein the seal includes an epoxy.
Aspect 67: The battery system of Aspect 63, wherein the post includes a bushing.
Aspect 68: The battery system of Aspect 63, wherein the post includes a pin.
Aspect 69: The battery system of Aspect 63, further comprising a terminal extending through the wall between the cells compartment and the battery monitoring system compartment, wherein the terminal includes lead.
Aspect 70: The battery system of one of Aspects 63-69, wherein the post incudes a first cylindrical wall having a first diameter and a second cylindrical wall having a second diameter, the second diameter being different from the first diameter.
Aspect 71: The battery system of Aspect 70, wherein the post further includes a tapered wall between the first wall and the second wall.
Aspect 72: The battery system of Aspect 70, wherein the second cylindrical wall receives a connector of the sensor.
Aspect 73: The battery system of one of Aspects 63-72, wherein the battery cell includes a positive plate, a negative plate, and a separator, and wherein at least one of the plates comprises lead.
Aspect 74: A vehicle comprising the lead-acid battery system of one Aspect 73.
Aspect 75: A lead-acid battery system comprising:
   - a housing defining at least in part a cells compartment and at least in part a battery monitoring system (BMS) compartment, and including a wall disposed between the cells compartment and the BMS compartment;
   - a battery cell housed in the cells compartment, the battery cell having a first post and a second post associated with the battery cell, the first post and the second post protruding through the wall between the cells compartment to the BMS compartment; and
   - a battery monitor system (BMS) housed by the BMS compartment, the BMS including a voltage sensor electrically coupled to the first post and the second post.
Aspect 76: The lead-acid battery system of Aspect 75, wherein the battery system further comprises a second battery cell housed in the cells compartment, the second battery cell having a third post and a fourth post associated with the second battery cell, the third post and the fourth post protruding through the wall between the cells compartment to the BMS compartment, and wherein the BMS further includes a second voltage sensor electrically coupled to the third post and the fourth post.
Aspect 77: The lead-acid battery system of Aspect 76, wherein the battery system further comprises a third battery cell, the third battery cell having the second post and the third post associated with the third battery cell, the second post and the third post protruding through the wall between the cells compartment to the BMS compartment, and wherein the BMS further includes a third voltage sensor electrically coupled to the second post and the third post.
Aspect 78: The lead-acid battery system of Aspect 77, further comprising:
   - a first terminal strap electrically coupling the battery cell to the second battery cell;
   - a second terminal strap electrically coupling the second battery cell to the third battery cell; and wherein the first terminal strap includes the second post, and the second terminal strap includes the third post.
Aspect 79: The lead-acid battery system of one of Aspects 75-78, wherein the housing further includes a cell base, a cell cover, a BMS base, and a BMS cover, and wherein the cell cover and the BMS base includes the wall between the cells compartment the BMS compartment.
Aspect 80: The lead-acid battery system of one of Aspects 75-78, wherein the BMS further includes one or more of a battery voltage sensor to sense a battery voltage, a battery current sensor to sense a battery current, and a temperature sensor to sense a temperature.
Aspect 81: The lead-acid battery system of one of Aspects 75-78, wherein the battery cell includes a positive plate, a negative plate, and a separator, and wherein at least one of the plates comprises lead.
Aspect 82: A vehicle comprising the lead-acid battery system of one of Aspects 75-81.
Aspect 83: A method of monitoring a lead-acid battery comprising a plurality of cells, the method comprising:
   - sensing a first temperature of a first one or more cells of the plurality of cells;
   - sensing a second temperature associated with the lead-acid battery; and
   - determining a state of the lead-acid battery based on the first temperature and the second temperature.
Aspect 84: The method of Aspect 83, and further comprising:
   - determining a temperature value based on the sensed first cell temperature;
   - monitoring whether the temperature value traverses a threshold value; and
   - identifying a first state for the lead-acid battery when the temperature value traverses the threshold value.
Aspect 85: The method of Aspect 84, wherein the threshold value indicates the first cell temperature is high, and the first state is a potential fault with the first cell.
Aspect 86: The method of Aspect 84, wherein the threshold value indicates a first cell temperature is high, and the first state is a potential fault with the lead-acid battery.
Aspect 87: The method of one of Aspects 83-86, wherein the second temperature is an ambient or environment temperature for the lead-acid battery; and wherein the determining the state of the lead-acid battery is further based on the second temperature.
Aspect 88: The method of one of Aspects 83-86, wherein the second temperature is a second cell temperature of a second one or more cells of the plurality of cells; and wherein the determining the state of the lead-acid battery is further based on the second temperature.
Aspect 89: A lead-acid battery system comprising:
   - a lead-acid battery comprising a plurality of cells;
   - a first temperature sensor to sense a first temperature;
   - a second temperature sensor to sense a second temperature; and
   - a battery monitoring unit coupled to the first temperature sensor, the second temperature sensor, and the lead-acid battery, the battery monitoring unit to perform one of the methods set forth in Aspects 83-88.
Aspect 90: A vehicle comprising the lead-acid battery system of Aspect 89.
Aspect 91: A method of monitoring for a fault with a lead-acid battery system for use in an automated vehicle, the method comprising:
   - determining a level of automation for the vehicle for the lead-acid battery system to be placed in;
   - determining a threshold value indicative of a fault based on the level of automation;
   - monitoring a parameter of the battery system;
   - comparing a value of the parameter to the threshold value; and
   - determining a possible fault based on the comparison.
Aspect 92: The method of Aspect 91, wherein determining a level of automation includes receiving the level of automation.
Aspect 93: The method of one of Aspects 91 or 92, wherein the fault relates to a functional safety condition of the battery system, the vehicle, or both the battery and the vehicle.
Aspect 94: The method of one of Aspects 91 or 92, wherein the fault relates to a potential usage fault of the battery system, the vehicle, or both the battery system and the vehicle.
Aspect 95: The method of one of Aspects 91 or 92, wherein the fault relates to a potential load fault of the battery system, the vehicle, or both the battery system and the vehicle.
Aspect 96: The method of one of Aspects 91-95, wherein the level of automation is based on SAE International automation levels.
Aspect 97: The method of one of Aspects 91-96, the method comprising:
   - modifying operation of the lead-acid battery system based on the possible fault.
Aspect 98: A lead-acid battery system comprising:
   - a lead-acid battery comprising a plurality of cells;
   - a sensor to monitor the parameter; and
   - a battery monitoring unit coupled to the sensor and the lead-acid battery, the battery monitoring unit to perform one of the methods set forth in Aspects 91-97.
Aspect 99: A vehicle comprising the lead-acid battery system of Aspect 91.
Aspect 100: A method of responding to a possible fault of a lead-acid battery system for use in an apparatus, the method comprising:
   - monitoring a cell-level parameter of the lead-acid battery system;
   - comparing a value of the cell-level parameter to a threshold;
   - determining a possible fault based on the comparison; and
   - communicating the possible fault to the apparatus.
Aspect 101: The method of Aspect 100 and further comprising modifying operation of the apparatus based on the possible fault.
Aspect 102: The method of one of Aspects 100 or 101, and further comprising:
   - charging the lead-acid battery system by the system using a first charging technique; and
   - modifying the charging of the lead-acid battery system by the system based on the possible fault, wherein the modification results in a second charging technique.
Aspect 103: The method of one of Aspects 100-102, and further comprising the apparatus communicating a message to replace the lead-acid battery system to an external device in response to the system receiving the possible fault communication.
Aspect 104: The method of one of Aspects 100-103, wherein the apparatus comprises a vehicle.
Aspect 105: A battery system comprising:
   - a housing;
   - a battery cell housed by the housing;
   - a sensor supported by the housing;
   - a processor and memory supported by the housing and in communication with the housing, the memory including instructions executable by the processor to perform the method of one of Aspects 100-103.
Aspect 106: A vehicle comprising the battery system of Aspect 105.
Aspect 107: A lead-acid battery system comprising:
   - a housing having a first compartment and a second compartment distinct from the first compartment;
   - lead-acid battery cells disposed in a first compartment;
   - a sensor disposed in the second compartment and to sense a stimulus associated with at least one of the lead acid battery cells;
   - a processor and memory disposed in the second compartment and in communication with the sensor, the memory including instructions executable by the processor to
      - cause the battery system to monitor a parameter based on the stimulus sensed by the sensor, and
      - determine a state of health, a state of function, or both a state of health and a state of function for the battery system based on the monitored parameter.
Aspect 108: The battery system of Aspect 107, wherein the battery cell includes a positive plate, a negative plate, and a separator, and wherein at least one of the plates comprises lead.
Aspect 109: A vehicle comprising the lead-acid battery system of Aspect 108.

Aspects herein can be embodied in other forms without departing from the spirit or essential attributes thereof. Accordingly, reference should be made to the following claims, rather than to the foregoing specification, as indicating the scope hereof.

## Claims

1. A method of monitoring a lead-acid battery system having a lead-acid battery with (n) battery cells, the method comprising:
- sensing (n) cell voltages associated with the (n) cells, each cell voltage of the (n) cell voltages being associated with a respective cell; and
- determining a state of the lead-acid battery based on the (n) cell voltages.

2. The method of claim 1, and further comprising:
- determining (n) voltage values based on the sensed (n) cell voltages, each cell voltage value of the (n) cell voltages being associated with a respective sensed cell voltage of the sensed (n) cell values;
- monitoring whether one or more of the (n) voltage values traverse a threshold value indicative of whether one or more cell voltages are low; and
- identifying a first state for the lead-acid battery when one or more of the (n) voltage values traverse the threshold value, wherein the first state is preferably a potential fault with the lead-acid battery.

3. The method of one claim 1 or 2,
wherein the state is a health of the lead-acid battery and wherein the determining the state includes determining a health of the lead-acid battery based on the (n) voltage values; or
wherein the state is a function of the lead-acid battery and wherein the determining the function includes determining the function of the lead-acid battery based on the (n) voltage values; or
wherein the state is a charge of the lead-acid battery and wherein the determining the charge includes determining a function of the lead-acid battery based on the (n) voltage values.

4. The method of one of claims 1 to 3,
wherein the lead-acid battery comprising a plurality of cells, and wherein the method comprises:
- sensing a first temperature of a first one or more cells of the plurality of cells;
- sensing a second temperature associated with the lead-acid battery; and
- determining a state of the lead-acid battery based on the first temperature and the second temperature.

5. The method of claim 4, and further comprising:
- determining a temperature value based on the sensed first cell temperature;
- monitoring whether the temperature value traverses a threshold value; and
- identifying a first state for the lead-acid battery when the temperature value traverses the threshold value.

6. The method of claim 5,
wherein the threshold value indicates the first cell temperature is high, and the first state is a potential fault with the first cell; or
wherein the threshold value indicates a first cell temperature is high, and the first state is a potential fault with the lead-acid battery.

7. The method of one of claims 4 to 6,
wherein the second temperature is an ambient or environment temperature for the lead-acid battery; and wherein the determining the state of the lead-acid battery is further based on the second temperature; and/or
wherein the second temperature is a second cell temperature of a second one or more cells of the plurality of cells; and wherein the determining the state of the lead-acid battery is further based on the second temperature.

8. A lead-acid battery system comprising:
- a lead-acid battery comprising (n) cells;
- one or more voltage sensors to sense (n) cell voltages; and
- a battery monitoring unit coupled to the one or more voltage sensors and the lead-acid battery, the battery monitoring unit to perform the method of one of claims 1 to 7.

9. A vehicle comprising the lead-acid battery system of claim 8.
